(19) Europäisches Patentamt / European Patent Office / Office européen des brevets

(11) **EP 3 276 695 A1**

(12) **EUROPEAN PATENT APPLICATION**
published in accordance with Art. 153(4) EPC

(43) Date of publication:
**31.01.2018 Bulletin 2018/05**

(51) Int Cl.:
**H01L 51/44** (2006.01)

(21) Application number: **16772672.8**

(22) Date of filing: **25.03.2016**

(86) International application number:
**PCT/JP2016/059714**

(87) International publication number:
**WO 2016/158791 (06.10.2016 Gazette 2016/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **27.03.2015 JP 2015067186
29.05.2015 JP 2015110252**

(71) Applicant: **Mitsubishi Chemical Corporation
Tokyo 100-8251 (JP)**

(72) Inventors:
• **NINOMIYA, Naoya**
Tokyo 1008251 (JP)
• **FUNAYAMA, Katsuya**
Tokyo 1008251 (JP)
• **MATSUSHITA, Yasunori**
Tokyo 1008251 (JP)
• **HIURA, Osamu**
Tokyo 1008251 (JP)

(74) Representative: **Hoffmann Eitle
Patent- und Rechtsanwälte PartmbB
Arabellastraße 30
81925 München (DE)**

(54) **ORGANIC THIN FILM SOLAR CELL MODULE**

(57) Provided is an organic photovoltaic module in which the initial performance of an organic photovoltaic device can be maintained even after squeegeeing in wet pasting construction, of which an end does not peel off in finishing working, and which has favorable design quality. The organic photovoltaic module includes, in turn, a first gas barrier layer, a first sealing layer, and the organic photovoltaic device, in which the first sealing layer has a storage modulus of $5 \times 10^6$ Pa or more and $1 \times 10^8$ Pa or less at 25°C and a frequency of 10 Hz.

Sun Light

Fig.1

EP 3 276 695 A1

**Description**

Technical Field

The present invention relates to an organic photovoltaic module.

Background Art

In recent years, transparent film-type photovoltaic modules using dye-sensitized photovoltaics, organic photovoltaics, and the like have been developed. In particular, such transparent film-type photovoltaic modules have light weights and are enabled to be flexible; and therefore, it has been examined to place and use such transparent film-type photovoltaic modules on buildings and the like. For example, in Patent Literature 1, a photovoltaic power generation film that is pasted and used on a window glass of a building has been proposed as a product to which a transparent film-type photovoltaic module is applied.

Citation List

Patent Literature

Patent Literature 1: Japanese Patent Laid-Open No. 2012-186310

Summary of Invention

Technical Problem

Such a photovoltaic power generation film as described above is placed and used on a conspicuous area such as a window glass, and high design quality is therefore demanded of the photovoltaic power generation film. Therefore, construction finishing of a thin film photovoltaic module on glass or the like and handling of a photovoltaic module are considered to be important.

A common wind film is pasted on glass by a method referred to as "wet pasting." In the method referred to as "wet pasting", water containing a slight amount of neutral detergent is sprayed on an adhesive face of a film and a face of glass by a sprayer, followed by temporarily pasting the film on the glass and then uniformly running a squeegee across a film surface in turn to bring the film and the glass into intimate contact with each other in order to paste the film on the glass. As a result, water and bubbles between the film and the glass are removed from an end of the film, and a favorable pasting face including neither folds nor bubbles can be obtained.

However, when the present inventors produced a thin film photovoltaic module including a configuration according to Patent Literature 1 and pasted the thin film photovoltaic module on window glass by wet pasting, it was found that interlayer peeling may occur in a photovoltaic device depending on a squeegee pressure in construction and on handling of the thin film photovoltaic module in finishing working or construction. A color tone greatly changes, and therefore, the design quality of a thin film photovoltaic module is notably impaired in a portion in which interlayer peeling occurs, in comparison with in a portion in which no interlayer peeling occurs.

In other words, the present invention is to provide a thin film photovoltaic module of which the design quality is not impaired in, e.g., construction of the thin film photovoltaic module on a construction object.

Solution to Problem

As a result of intensively examining the configuration of a thin film photovoltaic module in order to solve the problems described above, the present inventors found that:

(i) the electricity generation efficiency of the thin film photovoltaic module is higher in a case in which the substrate of a thin film photovoltaic device is in a light-receiving surface side;
(ii) the thin film photovoltaic device may be damaged when the storage modulus of a sealing layer is not within a certain range in a case in which the substrate of the thin film photovoltaic device is in the light-receiving surface side, i.e., in the case of performing squeegee construction of a thin film photovoltaic device side with respect to the device substrate; and
(iii) the thin film photovoltaic device may be damaged in squeegee construction when the thickness of a first sealing layer (a sealing layer in a side in which the squeegee construction is performed) is too small, and
the present invention was thus accomplished.

In other words, the gist of the present invention is as follows.

[A1] An organic photovoltaic module including, in turn, a first gas barrier layer, a first sealing layer, and an organic photovoltaic device,
wherein the first sealing layer has a storage modulus of $5 \times 10^6$ Pa or more and $1 \times 10^8$ Pa or less at 25°C and a frequency of 10 Hz.
[A2] The organic photovoltaic module according to [A1], wherein the organic photovoltaic module is flexible.
[A3] The organic photovoltaic module according to [A1] or [A2], wherein the first sealing layer has a thickness of 20 $\mu$m or more and 200 $\mu$m or less.
[A4] The organic photovoltaic module according to any one of [A1] to [A3], wherein the organic photovoltaic module includes, in turn, a first gas barrier layer, a first sealing layer, an organic photovoltaic device, a second sealing layer, and a second gas barrier layer.
[A5] The organic photovoltaic module according to [A4], wherein a light-receiving surface is in a second sealing layer side with respect to the organic photovoltaic device.
[A6] The organic photovoltaic module according to any one of [A1] to [A5], wherein the organic photovoltaic module includes, in turn, a first gas barrier layer, a first sealing layer, a thin film photovoltaic device, a second sealing layer, a second gas barrier layer, and an adhesive layer.

The present inventors produced a thin film photovoltaic module of which the configuration is the same as a configuration in Patent Literature 1 except that a power collection line is placed on an organic photovoltaic device, and examined placement of the thin film photovoltaic module on a window glass. As a result, bubbles between the glass and the thin film photovoltaic module remained outside the placement site of the power collection line.
This is because the thickness of the site in which the power collection line was placed was increased in response to the thickness of the power collection line while the peripheral edge of the thin film photovoltaic module became thin because the organic photovoltaic device was not layered on the peripheral edge, and as a result, the thin film photovoltaic module had regions having different thicknesses, and the removal of the bubbles by the squeegee was not able to be appropriately performed.
In addition, the thin film photovoltaic module includes a barrier layer in order to suppress degradation in the organic photovoltaic device, and it is therefore difficult to remove the bubbles by vaporization.
For these reasons, design quality after the placement of the thin film photovoltaic module on the glass was found to be deteriorated by sealing the power collection line together with the organic photovoltaic device.
As a result of performing intensive examination with attention to the thicknesses of a barrier layer and a sealing layer in order to solve such problems, the present inventors found that the problems are solved by allowing the difference between the thickness of a thin film photovoltaic module in a region in which a power collection line is further placed on an organic photovoltaic device and the thickness of the thin film photovoltaic module in a region in which the organic photovoltaic device is not sealed to be within a certain range. In other words, the other gist of the present invention may be as follows.

[B1] An organic photovoltaic module including, in turn, a first gas barrier layer, a first sealing layer, an organic photovoltaic device, a second sealing layer, and a second gas barrier layer, the organic photovoltaic module further including, a power collection line connected electrically to the organic photovoltaic device between the first sealing layer and the organic photovoltaic device,
wherein the thickness x ($\mu$m) of the organic photovoltaic module in the center of a power collection line placement region in the width direction of the power collection line and the thickness y ($\mu$m) of the thin film photovoltaic module at a position 5 mm outside from the peripheral edge of the organic photovoltaic device satisfy the following expression (I):

$$(x - y) \leq 90 \quad (I).$$

[B2] An organic photovoltaic module according to [B1], the organic photovoltaic module including, in turn, the first gas barrier layer, the first sealing layer, the organic photovoltaic device, the second sealing layer, the second gas barrier layer, and an adhesive layer.

Advantageous Effects of Invention

In accordance with the present invention, there can be provided a thin film photovoltaic module in which the initial performance of an organic photovoltaic device is maintained even after squeegee construction in wet pasting construction. In addition, in accordance with the present invention, there can be provided the thin film photovoltaic module of which an end does not peel off in finishing working, and which has favorable design quality.

In accordance with the other gist of the present invention, there can be provided an organic photovoltaic module of which the design quality is maintained even in wet pasting construction.

Brief Description of Drawings

[Figure 1] Figure 1 is a schematic cross-sectional view of a thin film photovoltaic module as one embodiment of the present invention.
[Figure 2] Figure 2 is a schematic cross-sectional view of a thin film photovoltaic module as one embodiment of the present invention.
[Figure 3] Figure 3 is a schematic cross-sectional view of a thin film photovoltaic module as one embodiment of the present invention.
[Figure 4] Figure 4 is a schematic cross-sectional view of a thin film photovoltaic module as another embodiment of the present invention.

Description of Embodiments

Embodiments of the present invention will be described in detail below. The description of constituent features described below is an example (representative example) of the embodiments of the present invention, and the present invention is not limited to the contents thereof unless deviating from the gist of the present invention.

An organic photovoltaic module according to one embodiment of the present invention is an organic photovoltaic module including, in turn, a first gas barrier layer, a first sealing layer, and an organic photovoltaic device, wherein the first sealing layer has a storage modulus of $5 \times 10^6$ Pa or more and $1 \times 10^8$ Pa or less at 25°C and a frequency of 10 Hz. It is preferable that the organic photovoltaic module further includes a second sealing layer and a second gas barrier layer in the order mentioned as well as the first gas barrier layer, the first sealing layer, and the organic photovoltaic device. It is preferable that in the organic photovoltaic module, a light-receiving surface is in a second sealing layer side with respect to the organic photovoltaic device. In addition, it is preferable that the organic photovoltaic device includes an device substrate in the second sealing layer side.

1. Organic Photovoltaic Module

1.1 Configuration

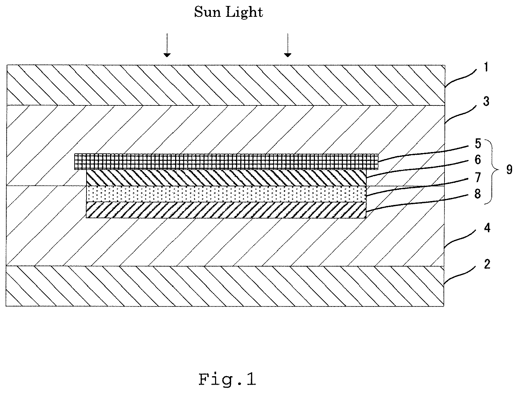

The organic photovoltaic module according to one embodiment of the present invention includes, in turn, a first gas barrier layer 2, a first sealing layer 4, an organic photovoltaic device 9, a second sealing layer 3, and a second gas barrier layer 1, as illustrated in the schematic cross-sectional view of Figure 1. A power collection line for extracting electricity (not illustrated in Figure 1) is typically placed on the upper or lower electrode of each photovoltaic forming an organic solar battery in a case in which electricity is extracted from the organic photovoltaic device.

The organic photovoltaic device 9 typically includes a structure in which a lower electrode 6, a photoelectric conversion layer 7, and an upper electrode 8 are layered in turn on an device substrate 5. According to the electricity generation mechanism of the organic photovoltaic device 9, because electricity can be generated even if a substrate side is either a light-receiving surface side or a non-light-receiving surface side with respect to a light-receiving surface for light contributing to generation of electricity, such as sunlight. The order of the device substrate 5, the lower electrode 6, the photoelectric conversion layer 7, and the upper electrode 8 from the light-receiving surface side as in Figure 1 is preferred from the viewpoint of the electricity generation efficiency of the thin film photovoltaic device. Of course, the order is not particularly restricted.

The first sealing layer 4 and the second sealing layer 3 (hereinafter, the combination of the first sealing layer and the second sealing layer may be referred to as "sealing layer"), which are layers disposed in order to seal the thin film photovoltaic device 9, are disposed to cover most of the thin film photovoltaic device 9. Typically, the first sealing layer 4 and the second sealing layer 3 are disposed to completely cover the thin film photovoltaic device 9 with the first sealing layer 4 and the second sealing layer 3, thereby sealing the thin film photovoltaic device 9. The positional relationship between the first gas barrier layer 2 and the second gas barrier layer 1 (hereinafter, the combination of the first gas barrier layer and the second gas barrier layer may be referred to as "gas barrier layer") and the sealing layer, and the relative sizes of the gas barrier layer and the sealing layer are not particularly restricted. Typically, however, the sealing layer and the gas barrier layer having the same size and the same shape are layered so that the ends of the sealing layer and the gas barrier layer are evened up; or the sealing layer and the gas barrier layer are layered so that the entire surface of the sealing layer is covered with the gas barrier layer and the gas barrier layer is larger than the sealing layer. For preventing degradation due to water or oxygen and for maintaining the performance of the photovoltaic device for a long period, it is preferable to place an end face of the gas barrier layer outside an end face of the device substrate so that the distance between the end face of the gas barrier layer and the end face of the device substrate is 5 mm or more.

It is preferable that the thin film photovoltaic module in the present embodiment includes an adhesive layer for pasting the thin film photovoltaic module on a construction object in an outermost layer of the thin film photovoltaic module and is placed on a window glass or the like by the adhesive layer.

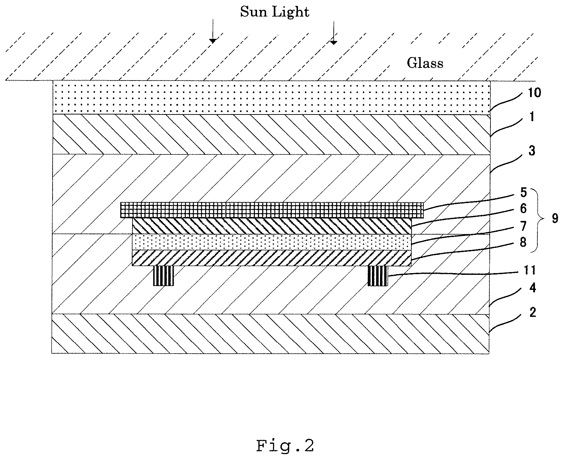

For example, a configuration can be made in which an adhesive layer 10 is disposed on a second gas barrier layer 1, and a first gas barrier layer 2, a first sealing layer 4, a thin film photovoltaic device 9, a second sealing layer 3, the second gas barrier layer 1, and the adhesive layer 10 are in turn included, as illustrated in Figure 2. As the adhesive layer 10, a conventionally known pressure sensitive adhesive can be used, and an acrylic pressure sensitive adhesive is preferably used from the viewpoint of weather resistance and transparency. The adhesive layer can be disposed on an outermost layer of a substrate side (light-receiving surface) or a photoelectric conversion layer side (non-light-receiving surface) of the thin film photovoltaic device used in the thin film photovoltaic module by a known method, and it is preferable to dispose the adhesive layer on the outermost layer of the substrate side (light-receiving surface) of the thin film photovoltaic device from the viewpoint of the electricity generation efficiency of the thin film photovoltaic device.

The adhesive layer 10 is pasted on a construction object such as a glass window, thereby placing the thin film photovoltaic module on the construction object.

It is preferable that the organic photovoltaic module has a light-transmitting property. With regard to the light-transmitting property of the thin film photovoltaic module, the thin film photovoltaic module has a visible light transmittance, measured by the method according to JIS R 3106, of typically 3% or more, preferably 5% or more, more preferably 8% or more, still more preferably 10% or more, and particularly preferably 20% or more, and typically 80% or less, preferably 60% or less, and more preferably 50% or less. A visible light transmittance of not less than the above-described lower limit is preferred in view of enabling improvement in lighting performance. A visible light transmittance of not more than the above-described upper limit is preferred in view of enabling improvement in electricity generation efficiency.

The organic photovoltaic module having a light-transmitting property can be actualized by, for example, using a transparent electrode as the electrode of the organic photovoltaic device to make the organic photovoltaic device having a light-transmitting property and allowing the configuration members of the organic photovoltaic module, other than the organic photovoltaic device, to be members having light-transmitting properties.

It is preferable that the organic photovoltaic module according to the present embodiment is an organic photovoltaic module with flexibility. By imparting the organic photovoltaic module with flexibility, the organic photovoltaic module is enabled to be transported in a roll form, and is improved in handleability. In the organic photovoltaic module according to the present invention, interlayer peeling in the organic photovoltaic device due to bending is inhibited from occurring, as described later. Therefore, the present invention is suitable particularly for the organic photovoltaic module with flexibility. Such flexibility herein means that the thin film photovoltaic module is not broken (not plastically deformed) even if being bent at a curvature radius of 170 mm. The thin film photovoltaic module has flexibility, preferably in which the thin film photovoltaic module is not broken even if being bent at a curvature radius of 85 mm, more preferably in which the thin film photovoltaic module is not broken even if being bent at a curvature radius of 50 mm, and particularly preferably in which the thin film photovoltaic module is not broken even if being bent at a curvature radius of 35 mm. For example, use of a material satisfying the above-described flexibility as the material of an device substrate described later, appropriate adjustment of the thickness and elasticity modulus of each member forming the organic photovoltaic module, and the like enable the thin film photovoltaic module to satisfy the above-described flexibility.

The configuration members of the organic photovoltaic module of the present invention will be described below.

1.2 Configuration Members

1.2.1 Gas Barrier Layer (First Gas Barrier Layer and Second Gas Barrier Layer)

The gas barrier layer is a layer that prevents transmission of water and oxygen.

The organic photovoltaic device is prone to be vulnerable to moisture and oxygen, and in particular, the transparent electrode and the photoelectric conversion layer forming the organic solar battery may be degraded by water or oxygen. Thus, covering of the thin film photovoltaic device with the gas barrier layer enables the organic photovoltaic device to be protected from water and oxygen, whereby electricity generation performance can be highly maintained.

The degree of moisture-proofing ability required by the gas barrier layer is a moisture vapor transmission rate per unit area (1 m$^2$) per day of preferably $1 \times 10^{-1}$ g/m$^2$/day or less, more preferably $1 \times 10^{-2}$ g/m$^2$/day or less, still more

preferably $1 \times 10^{-3}$ g/m²/day or less, especially preferably $1 \times 10^{-4}$ g/m²/day or less, notably preferably $1 \times 10^{-5}$ g/m²/day or less, and particularly preferably $1 \times 10^{-6}$ g/m²/day or less. The more the transmission of water vapor is suppressed, the more the degradation due to reaction between the thin film photovoltaic device and the water of the transparent electrode such as ZnO: Al of the device is suppressed. Therefore, the life of the organic photovoltaic module is prolonged by maintaining electricity generation efficiency. Application of such a gas barrier layer facilitates implementation of the organic photovoltaic module making use of the excellent properties of the organic photovoltaic device.

As the gas barrier layer, a gas barrier layer that transmits visible light is preferred from the viewpoint of preventing the organic photovoltaic device from being inhibited from absorbing light. For example, the transmittance of visible light (wavelengths of 360 to 830 nm) measured by the method according to JIS R 3106 is typically 60% or more, preferably 70% or more, more preferably 75% or more, still more preferably 80% or more, especially preferably 85% or more, notably preferably 90% or more, particularly preferably 95% or more, and especially particularly preferably 97% or more. This is because sunlight is converted into more electric energy.

As the gas barrier layer, a gas barrier layer having a low degree of cloudiness (haze) is preferred from the viewpoint of design quality such as a sense of unity with a construction object, or appearance. For example, a haze value in the case of using a D65 light source defined in JIS K 7136 is typically 10 or less, preferably 5 or less, more preferably 2 or less, and still more preferably 1 or less.

It is preferable that the gas barrier layer also has resistance to heat because the organic photovoltaic module is often heated by receiving light. From this viewpoint, the melting point of the component material of the gas barrier layer is typically 100°C or more, preferably 120°C or more, and more preferably 130°C or more, and typically 350°C or less, preferably 320°C or less, and more preferably 300°C or less. A possibility that the gas barrier layer melts and degrades when the thin film photovoltaic module is used can be reduced by raising the melting point.

The specific configuration of the gas barrier layer is arbitrary as long as the organic photovoltaic device can be protected from water or oxygen. However, the less the possible amount of water vapor and oxygen that can be transmitted through the gas barrier layer in such a configuration is, the higher the manufacture cost of the configuration is. Therefore, it is preferable to use an appropriate gas barrier layer in comprehensive consideration of these points. Specifically, a configuration in which an inorganic layer is layered on a resin substrate is preferred.

A material which forms the resin substrate is not particularly restricted, and examples thereof include: polyolefin resins such as homopolymers and copolymers of ethylene, propylene, and butene; amorphous polyolefin resins such as cyclic polyolefin; polyester resins such as polyethylene terephthalate (PET) and polyethylene naphthalate (PEN); polyamide resins such as nylon 6, nylon 66, nylon 12, and copolymer nylons; partially hydrolyzed ethylene-vinyl acetate copolymers (EVOH); polyimide resins; polyetherimide resins; polysulfone resins; polyethersulfone resins; polyether ether ketone resins; polycarbonate resins; polyvinyl butyral resins; polyarylate resins; fluorine resins; acrylic resins; and biodegradable resins. The resin substrate may be formed of two or more materials or may have a layered structure. Among them, polyester resins are preferred, and polyethylene terephthalate (PET) or polyethylene naphthalate (PEN) is particularly preferred, from the viewpoint of the physical properties of a film.

A material which forms the inorganic layer is not the particularly restricted, and examples thereof include silicon, aluminum, magnesium, zinc, tin, nickel, and titanium; oxides, carbides, nitrides, oxycarbides, oxynitrides, and oxycarbonitrides thereof; diamond-like carbon; and mixtures thereof. The inorganic layer may be formed of two or more materials or may have a layered structure. Among them, examples of the material which form the inorganic layer, preferred for preventing leakage of current, include silicon oxide, silicon carbide oxide, silicon nitride oxide, silicon nitride carbide oxide, aluminum oxide, aluminum carbide oxide, aluminum nitride oxide, silicon nitride, aluminum nitride, diamond-like carbon, and mixtures thereof. Among them, silicon oxide, silicon carbide oxide, silicon nitride oxide, silicon nitride carbide oxide, silicon nitride, aluminum oxide, aluminum carbide oxide, aluminum nitride oxide, aluminum nitride, and mixtures thereof are particularly preferred for enabling high moisture-proof properties to be stably maintained. The inorganic layer may be formed by plural inorganic materials. The inorganic layer may also include plural inorganic layers. In this case, the plural inorganic layers may also be formed of the same material or may also be formed of different materials. From the viewpoint of the design quality of the organic photovoltaic module, a preferred optical physical property is higher transparency, silicon oxide, silicon nitride oxide, and silicon nitride are preferred, and especially, silicon oxide is particularly preferred.

Among the above, preferred examples of the gas barrier layer include a film in which silicon oxide ($SiO_x$) is vacuum deposited on a substrate film such as polyethylene terephthalate (PET) or polyethylene naphthalate (PEN).

The gas barrier layer may be formed of one material or may be formed of two or more materials. The gas barrier layer may also be formed of a single layer or may also be a layered body including two or more layers.

The thickness of the gas barrier layer is not particularly defined, and is typically 10 μm or more, preferably 15 μm or more, and more preferably 20 μm or more, and typically 200 μm or less, preferably 180 μm or less, and more preferably 150 μm or less. The larger thickness tends to result in an enhanced gas barrier property while the smaller thickness tends to result in enhanced flexibility and the improved transmittance of visible light.

The storage modulus of the gas barrier layer at 25°C and a frequency of 10 Hz is not particularly limited. When the storage modulus is $1.0 \times 10^8$ Pa or more, preferably $3.0 \times 10^8$ Pa or more, and $6.0 \times 10^9$ Pa or less, preferably $4.0 \times 10^9$ Pa or less, the present invention can more prominently exhibit effects for the following reasons. When the storage modulus of the gas barrier layer is not more than the upper limit described above, the influence of the pressure of a squeegee in squeegeeing on the organic photovoltaic device tends to become large. When the storage modulus of the gas barrier layer is not more than the lower limit described above, interlayer peeling in the organic photovoltaic device tends to easily occur due to stress generated in the case of bending the thin film photovoltaic module. Therefore, the present invention can more prominently exhibit the effects when the gas barrier layer is used.

A position at which the gas barrier layer is formed is not restricted as long as the organic photovoltaic device can be covered with the gas barrier layer and can be protected from moisture and oxygen, and it is preferable to cover both the end faces of the thin film photovoltaic device in a layering direction, specifically, the face in the light-receiving surface side (the face of the lower side in Figure 1) and the face opposite to the light-receiving surface (the face of the upper side in Figure 1).

The positional relationship between the gas barrier layer and the sealing layer, and the relative sizes of the gas barrier layer and the sealing layer are not particularly restricted. Typically, however, the sealing layer and the gas barrier layer having the same size and the same shape are layered so that the ends of the sealing layer and the gas barrier layer are evened up; or the sealing layer and the gas barrier layer are layered so that the entire surface of the sealing layer is covered with the gas barrier layer and the gas barrier layer is larger than the sealing layer. For preventing degradation due to water or oxygen and for maintaining the performance of the organic photovoltaic device for a long period, it is preferable to place an end face of the gas barrier layer outside an end face of the device substrate so that the distance between the end face of the gas barrier layer and the end face of the device substrate is 5 mm or more.

A hard coat layer may be disposed on the gas barrier layer in order to prevent flawing in handling of the organic photovoltaic module, to prevent flawing due to a squeegee in wet pasting on a construction object, and to improve the smoothness of the gas barrier layer.

1.2.2 Sealing Layer (First Sealing Layer and Second Sealing Layer)

In the embodiment of the present invention, it is preferable to seal the thin film photovoltaic device with a sealing material, thereby protecting the thin film photovoltaic device, in the process of producing the thin film photovoltaic module. The thin film photovoltaic device is sealed in order to reinforce the thin film photovoltaic device and to improve impact resistance.

The storage modulus of the first sealing layer at 25°C and a frequency of 10 Hz is preferably $5.0 \times 10^6$ Pa or more, still more preferably $7.0 \times 10^6$ or more, and particularly preferably $1.0 \times 10^7$ Pa or more, and preferably $5.0 \times 10^8$ Pa or less, still more preferably $3.0 \times 10^8$ Pa or less, and particularly preferably $1.0 \times 10^8$ Pa or less, for the following reasons. The storage modulus was regarded as a storage modulus at 25°C in consideration of temperature in typical squeegee construction. In a method of measuring the storage modulus, the storage modulus is determined by melting the sealing layer, then working it into a test piece (including curing treatment in the case of requiring curing), and measuring the temperature dispersion of the obtained test piece using a conventionally known dynamic viscoelasticity measurement apparatus.

Examination performed by the present inventors revealed that portions with low adhesiveness in the organic photovoltaic device is more than those in, for example, a silicon-based photovoltaic device in which amorphous silicon or the like is used, and the organic photovoltaic device tends to more easily peel off than the silicon-based photovoltaic device because an organic semiconductor compound is used in the photoelectric conversion layer and the like. Therefore, it was found that more consideration of interlayer peeling due to pressure from the outside, and the like is required for practical use of the thin film photovoltaic module in which the organic photovoltaic device is used, than that for practical use of a silicon-based photovoltaic.

When the organic photovoltaic module is wet-pasted on a construction object such as a window glass from a first gas barrier layer side by squeegee construction, deformation of not only the first gas barrier layer but also the first sealing layer occurs, and the deformation reaches the organic photovoltaic device in a case in which the storage modulus of the first sealing layer is too low. Therefore, stress is applied to the organic photovoltaic device, interlayer peeling occurs in the organic photovoltaic device, part of the organic photovoltaic device is broken, and conversion efficiency is decreased. In addition, the photoelectric conversion layer of the organic photovoltaic device is commonly colored, a color tone is therefore notably differs between a portion in which interlayer peeling occurs and a portion in which interlayer peeling does not occur, and therefore, design quality is notably deteriorated. In contrast, in a case in which the storage modulus of the first sealing layer is too high, interlayer strength in the organic photovoltaic device is unable to endure the bending stress of the first sealing layer, and interlayer peeling occurs in the device when an end of the photovoltaic module is trimmed in the finishing working of the thin film photovoltaic module or the thin film photovoltaic module is bent. As a result, conversion efficiency is decreased, and the design quality of the organic photovoltaic module is notably deteriorated.

Because a thick device substrate is commonly arranged between the second sealing layer and the organic photovoltaic device, the stress of the second barrier layer can be reduced by the device substrate, for example, in the case of construction from a second barrier layer side. Therefore, the storage modulus of the second sealing layer at 25°C and a frequency of 10 Hz is not particularly restricted. However, it is preferable that the second barrier layer also has a storage modulus similar to the storage modulus of the first barrier layer in order to prevent the warpage of the organic photovoltaic module, and the like.

As the sealing layer, a the sealing layer that transmits visible light is preferred from the viewpoint of preventing the organic photovoltaic device from being inhibited from absorbing light when the sealing layer is used in the light-receiving surface side of the organic photovoltaic device. For example, the light transmittance of visible light (wavelengths of 360 to 830 nm) measured by the method according to JIS R 3106 is typically 75% or more, preferably 80% or more, more preferably 85% or more, still more preferably 90% or more, especially preferably 95% or more, and particularly preferably 97% or more in a single sealing layer. This is because sunlight is converted into more electric energy.

As the sealing layer, a sealing layer having a low degree of cloudiness (haze) is preferred from the viewpoint of design quality such as a sense of unity with a construction object, or appearance. For example, a haze value in the case of using a D65 light source defined in JIS K 7136 is typically 15 or less, preferably 10 or less, more preferably 5 or less, and still more preferably 2 or less in a single sealing layer.

In contrast, when a sealing material is used in the side opposite to the light-receiving surface of the organic photovoltaic device, it is not necessary that the sealing material transmits visible light, and the sealing material may be opaque; however, when the sealing material is pasted on a transparent construction object such as a window glass, it is preferable that the sealing layer has visible light transmittance and a degree of cloudiness similar to those of the light-receiving surface side of the organic photovoltaic device.

It is preferable that the sealing layer also has resistance to heat because the organic photovoltaic module is often heated by receiving light. From this viewpoint, the melting point of the component material of the sealing layer is typically 100°C or more, preferably 120°C or more, and more preferably 130°C or more, and typically 350°C or less, preferably 320°C or less, and more preferably 300°C or less. By raising the melting point, the sealing layer can be prevented from melting and degrading when the organic photovoltaic module is used.

In a case in which the sealing layer has a melting point, the melting point of the sealing layer is preferably 50°C or more, preferably 80°C or more, and still more preferably 100°C or more from the viewpoint of suppressing the deformation of the organic photovoltaic module itself when the organic photovoltaic module is used. In contrast, the melting point of the sealing layer is preferably 250°C or less, still more preferably 200°C or less, more preferably 180°C or less, especially preferably 160°C or less, and particularly preferably 140°C or less from the viewpoint of preventing warpage and waviness from occurring in the organic photovoltaic module due to the increased thermal expansion and thermal contraction of the members other than the sealing layer in the production of the manufacture of the photovoltaic module. In a case in which the sealing layer has no melting point, it is preferable that the sealing layer has tackiness in the above-described temperature range in order to secure sufficient adhesiveness and adhesion with the organic photovoltaic device, the substrate, the gas barrier layer, and the other layers.

When the organic photovoltaic module includes both sealing layers of the first sealing layer and the second sealing layer, the lower limit of the sum of the thicknesses of the first sealing layer and the second sealing layer is not limited, and is typically 40 $\mu$m or more, preferably 60 $\mu$m or more, and more preferably 80 $\mu$m or more, and typically 800 $\mu$m or less, preferably 400 $\mu$m or less, more preferably 300 $\mu$m or less, and still more preferably 200 $\mu$m or less from the viewpoint of squeegee marks on the sealing layers. The larger thickness tends to result in an increase in the strength (resilience) of the overall organic photovoltaic module, while the smaller thickness tends to result in an increase in flexibility and in improvement in visible light transmittance. Therefore, it is desirable to set the thickness in the above-described range as a range exhibiting both advantages. When the thickness deviates from the above-described range, the excessively thick sealing layer may result in the deterioration of construction properties in squeegee construction in wet pasting, thereby allowing bubbles to remain between the organic photovoltaic module and a construction object, while the excessively thin sealing layer may result in damage to the organic photovoltaic device due to squeegee pressure, thereby causing the deterioration of the electricity generation performance of the device. The thickness of the sealing layer described above and the thickness of the sealing layer described later indicate thicknesses obtained from the results of cross-section observation of a cut surface with a microscope in the case of cutting the organic photovoltaic module after the production of the organic photovoltaic module.

Each thickness of the first sealing layer or the second sealing layer is not particularly defined, and is typically 20 $\mu$m or more, preferably 30 $\mu$m or more, more preferably 40 $\mu$m or more, and still more preferably 60 $\mu$m or more, and typically 400 $\mu$m or less, preferably 200 $\mu$m or less, more preferably 150 $\mu$m or less, and still more preferably 100 $\mu$m or less. The larger thickness enables damage to the organic photovoltaic device to be prevented, while the smaller thickness tends to result in improvement in visible light transmittance. Therefore, it is desirable to set the thickness in the above-described range as a range exhibiting both advantages.

When the organic photovoltaic module includes both sealing layers of the first sealing layer and the second sealing layer, the ratio T1/(T1 + T2) of the thickness T1 of the first sealing layer to the total thickness of the thickness T1 of the first sealing layer and the thickness T2 of the second sealing layer is not particularly defined, and is typically in a range of 0.3 to 0.7, preferably in a range of 0.4 to 0.6, and more preferably 0.5. The ratio of the thickness within the range can result in the favorable handleability of the organic photovoltaic module and in a reduction in bubbles remaining in wet pasting construction. In particular, the ratio that is not more than the upper limit enables the warpage of the organic photovoltaic module to be suppressed, thereby improving construction properties.

A material forming the sealing layer is not particularly limited, and may be a vinyl acetate-ethylene copolymer composition including a crosslinking agent; a thermosetting resin such as polyurethane or epoxy resin; a thermoplastic resin such as polyolefin resin, polyester, or acrylic resin; an elastomer resin such as butyl rubber or silicone rubber; or a composite of the above. Especially, epoxy resin, acrylic resin, or polyolefin resin is preferred as a material forming the first sealing layer from the viewpoint of transparency and because of facilitating control of a storage modulus and the like, and a bending elastic modulus depending on material composition.

The sealing layer may be formed of one material or may be formed of two or more materials. The sealing layer may be single-layered or may be layered.

The sealing layer may be imparted with a function such as ultraviolet shielding, heat ray shielding, conductivity, anti-reflection, an antiglare property, light diffusion, light scattering, wavelength conversion, or a gas barrier property. In particular, an organic photovoltaic may degrade due to water or oxygen and may be degrade due to ultraviolet light in sunlight, and therefore, it is preferable that the organic photovoltaic has a gas barrier property or an ultraviolet shielding function.

In a method for imparting such a function, a layer having a function may be layered on the sealing layer by coating, or the like, or a material exhibiting such a function may be incorporated into the sealing layer by, e.g., melting and dispersing the material.

Examples of such a gas barrier property include gas barrier properties satisfying the following moisture vapor transmission rate and oxygen permeability.

As the moisture vapor transmission rate, the moisture vapor transmission rate Pd of a sealing material having a thickness of 100 $\mu$m under an environment of 40°C and 90% RH is typically $10^{-1}$ g/m$^2$/day or less, preferably $10^{-2}$ g/m$^2$/day or less, more preferably $10^{-3}$ g/m$^2$/day or less, and still more preferably $10^{-4}$ g/m$^2$/day or less. The moisture vapor transmission rate is measured under an environment of 40°C and 90% RH by an apparatus including a moisture sensitive sensor, an infrared sensor, and a gas chromatograph according to JIS K7129, and a cup method (JIS Z0208).

Commonly, for example, an oxygen transmission rate per unit area (1 m$^2$) per day in a thickness of 100 $\mu$m under an environment of 25°C is typically 1 cc/m$^2$/day/atm or less, preferably $1 \times 10^{-1}$ cc/m$^2$/day/atm or less, more preferably $1 \times 10^{-2}$ cc/m$^2$/day/atm or less, still more preferably $1 \times 10^{-3}$ cc/m$^2$/day/atm or less, notably preferably $1 \times 10^{-4}$ cc/m$^2$/day/atm or less, and particularly preferably $1 \times 10^{-5}$ cc/m$^2$/day/atm or less as the oxygen permeability. There is an advantage that the less the oxygen permeates, the more greatly the degradation due to the oxidation of the organic photovoltaic device is suppressed. The oxygen transmission rate can be measured by an apparatus based on the differential pressure method according to JIS K7126A, or an apparatus including an infrared sensor and a gas chromatograph based on the equal pressure method according to JIS K7126B.

The sealing layer may be formed of a single-layer film or may be a layered film including two or more films which are layered. As a method for forming the sealing layer in a sheet or film form in advance, a known method, for example, an extrusion casting method, a calender method, or the like in which a T-die is used with a melt mixing facility such as a single screw extruder, a multi-screw extruder, a Banbury mixer, or a kneader can be adopted, and such a method is not particularly limited. Coating with the sealing layer as a coating liquid can be performed by a method of which examples include conventionally known coating methods such as a bar coating method, a roll coating method, a knife coating method, a roll knife coating method, a die coating method, a gravure coating method, an air doctor coating method, and a doctor blade coating method.

The sealing layer is typically formed by layering the sealing material and the organic photovoltaic device, and preferably formed by layering the layered body of the gas barrier layer and the sealing layer, and the organic photovoltaic device. The step of layering the sealing material on the thin film photovoltaic device may be performed after the step of placing the power collection line on the organic photovoltaic device (power collection line placement step) or may be performed before the power collection line placement step.

When the step of layering the sealing material on the organic photovoltaic device is performed after the power collection line placement step, the sealing material is layered on the organic photovoltaic device on which the power collection line is placed, and a slit is formed in the site, from which the power collection line is taken, of the sealing material, whereby the power collection line can be taken from the slit. The number of the points, through which the power collection line is connected to the upper electrode, of the organic photovoltaic device is arbitrary as long as being one or more. When plural organic photovoltaic devices are serially connected, the power collection line may be connected to the organic photovoltaic devices so that a desired potential can be extracted.

When the step of layering the sealing material on the organic photovoltaic device is performed before the step 1, a slit is formed in the sealing material after the sealing, and the upper electrode of the organic photovoltaic device is allowed to be in the state of being exposed in the slit. The upper electrode at the position of the slit and the power collection line may be connected to each other. The process of forming the slit after the sealing can be saved by disposing, in advance, the slit at the specific position in the sealing material before the sealing. The possibility of damage to the organic photovoltaic device caused by forming the slit after the sealing can be eliminated by disposing the slit in advance in such a manner.

1.2.3 Organic Photovoltaic Device

The organic photovoltaic device typically includes a structure in which the lower electrode, the photoelectric conversion layer, and the upper electrode are layered in turn on the device substrate (hereinafter also referred to simply as "substrate"). In the organic photovoltaic device, the sum of the total film thicknesses of layers forming the organic photovoltaic device including the device substrate is typically 300 $\mu$m or less, and the film thickness of a portion other than the device substrate is particularly preferably 150 $\mu$m or less.

As the material of the photoelectric conversion layer of the organic photovoltaic device, any material may be used unless the effects of the present invention are deteriorated, and an organic dye material, an organic semiconductor material, or the like is preferably used. Among them, use of an organic semiconductor material is particularly preferred because of being particularly excellent in productivity and satisfying the objects of the present invention.

An example of the organic photovoltaic device in which an organic semiconductor material is used will be described below.

1.2.3.1 Substrate (Device Substrate)

The substrate is a member that supports the organic photovoltaic device. The material of the substrate is not particularly limited as long as the present invention can be applied. A known material such as an inorganic material, an organic material, a paper material, or a composite material can be used as the material. Specific examples thereof include: inorganic materials such as quartz, glass, sapphire, and titania; polyolefins such as polyethylene terephthalate, polyethylene naphthalate, polyether sulfone, polyimide, nylon, polystyrene, polyvinyl alcohol, ethylene-vinylalcohol copolymers, fluorine resin films, vinyl chloride, and polyethylene; organic materials such as cellulose, polyvinylidene chloride, aramid, polyphenylene sulfide, polyurethane, polycarbonate, polyarylate, polynorbornene, and epoxy resins; paper materials such as papers and synthetic papers; and composite materials such as materials obtained by coating or laminating surfaces of metals such as stainless steel, titanium, and aluminum in order to impart insulating properties. Among them, a resin substrate using an organic material is preferred in view of enabling production of both structures of a superstrate structure and a substrate structure and enabling production of a see-through photovoltaic device with a light-transmitting property because transparency can be imparted to the substrate.

Especially, it is preferable that the substrate is a substrate which has flexibility (which is flexible). This is because the flexible substrate enables the organic photovoltaic device to be produced by a roll-to-roll method and allows the degree of freedom of placement of the organic photovoltaic device to be improved. The thin film photovoltaic module can be allowed to have flexibility. "Having flexibility" means that, for example, the substrate is not broken (plastically deformed) even if the substrate is bent at a curvature radius of 170 mm.

Among the materials described above, an organic material, a paper material, or a composite material is preferred, an organic material or a composite material is more preferred, and an organic material is particularly preferred, as the material of the flexible substrate.

Such an organic material typically has Tm (melting temperature) and Tg (glass transformation temperature). Deterioration of appearance due to the deformation of the substrate can be suppressed by sealing the organic photovoltaic device at less than Tm, preferably at less than Tg.

When the substrate is a resin substrate, the glass transformation temperature (Tg) of the resin substrate is typically 30°C or more, and preferably 50°C or more, and typically 400°C or less, preferably 300°C or less, more preferably 200°C or less, and still more preferably 160°C or less. The glass transformation temperature (Tg) within the above-described range facilitates molding in production of the resin substrate and inhibits deformation in working in production of the thin film photovoltaic module.

The glass transformation temperature in the present specification is a value determined by differential scanning calorimetry (DSC) defined in JIS K-7121 1987 "testing methods for transition temperatures of plastics."

The thickness of the substrate is not restricted, and is typically 5 $\mu$m or more, and preferably 20 $\mu$m or more, and typically 20 mm or less, and preferably 10 mm or less. A case in which the thickness of the substrate is 5 $\mu$m or more is preferred because of allowing the strength of the organic photovoltaic device to be less likely to be insufficient. A case in which the thickness of the substrate is 20 mm or less is preferred because of reducing a cost and preventing a weight from increasing. The thickness of the substrate of which the material is glass is typically 0.01 mm or more, and preferably 0.1 mm or more, and typically 1 cm or less, and preferably 0.5 cm or less. A case in which the thickness of the substrate is 0.01 mm or more is preferred because of increasing a mechanical strength and inhibiting cracking. A case in which the thickness of the substrate is 0.5 cm or less is preferred because of preventing a weight from increasing.

The storage modulus of the substrate at 25°C and a frequency of 10 Hz is not particularly restricted, and is set preferably at $6.0 \times 10^9$ Pa or less, and particularly preferably at $4.0 \times 10^9$ Pa or less in order to reduce a coefficient of restitution for damage to the organic photovoltaic device due to external stress in a case in which the thickness of the substrate is 5 $\mu$m or more and 20 mm or less. The storage modulus of the substrate having the film thickness at 25°C and a frequency of 10 Hz is set preferably at $1.0 \times 10^8$ Pa or more, and particularly preferably at $3.0 \times 10^8$ Pa or more in order to prevent the breakage of the organic photovoltaic device which can occur in handling of the substrate in production of the organic photovoltaic module.

The length of the substrate is not restricted, and is typically 10 cm or more, preferably 1 m or more, more preferably 10 m or more, still more preferably 50 m or more, and particularly preferably 100 m or more. The upper limit thereof is typically 10 km or less, preferably 5 km or less, more preferably 1 km or less, and still more preferably 500 m or less.

In the case of production by a roll-to-roll method, the length is typically 10 m or more, preferably 20 m or more, more preferably 50 m or more, still more preferably 100 m or more, and particularly preferably 200 m or more. The upper limit thereof is not particularly restricted, and is typically 10 km or less, preferably 5 km or less, and more preferably 1 km or less. Efficient production by the roll-to-roll method can be performed by setting the length in such a range. In the roll-to-roll method, switching of a roll is time-consuming, and therefore, the longer substrate of one roll, which is permitted by a production apparatus, is preferred for reducing a time loss due to the switching of the roll. It is necessary to note that handling becomes difficult due to a heavier roll.

1.2.3.2 Electrodes

The organic photovoltaic device includes a pair of electrodes including a lower electrode and an upper electrode. In the present invention, the lower electrode means an electrode that is arranged in a substrate side, and the upper electrode means an electrode that is arranged at an upper position than the position of the lower electrode on the assumption that the substrate is a bottom. The electrodes have the function of collecting holes and electrons generated by light absorption. Specifically, it is preferable to allow one electrode of the pair of electrodes to be an electrode (hereinafter may be referred to as "anode") suitable for collecting holes and to allow the other electrode to be an electrode (hereinafter may be referred to as "cathode") suitable for collecting electrons. The lower electrode may be the anode, and the upper electrode may be the cathode, or the lower electrode may be the cathode, and the upper electrode may be the anode. Either or both of the lower electrode and the upper electrode may have light-transmitting properties.

In the present invention, such an electrode has a sunlight transmittance, i.e., a rate of transmitted light having wavelengths of 360 to 830 nm to sunlight, of typically 40% or more, preferably 50% or more, more preferably 60% or more, and still more preferably 70% or more, when having a light-transmitting property.

A case in which the sunlight transmittance of such a transparent electrode is typically 70% or more is preferred for allowing light to be transmitted through the transparent electrode and to arrive at the photoelectric conversion layer.

Such light transmittances are values measured according to JIS7375: 2008.

The lower electrode and the upper electrode can be formed of a material having conductivity. Examples of the material include: metals such as platinum, gold, silver, aluminum, chromium, nickel, copper, titanium, magnesium, calcium, barium, and sodium, or alloys thereof; metal oxides such as nickel oxide, indium oxide, tungsten oxide, tin oxide, and zinc oxide; and composite oxides such as indium-tin oxide (ITO), indium-zinc oxide (IZO), and indium-tungsten oxide (IWO).

Especially, it is preferable to use a material having a high work function in the anode. In contrast, it is preferable to use a material having a low work function in the cathode. Optimization of such a work function has an advantage that holes and electrons generated by light absorption are favorably collected. The lower electrode and the upper electrode can be formed with a material having the same work function by adjusting the work function of a buffer layer when the buffer layer is disposed on the organic photovoltaic device, as described later.

At least one electrode of the pair of electrodes has a light-transmitting property as described above, and it is preferable that at least an electrode in a light-receiving surface side has a light-transmitting property and is preferably transparent. However, such an electrode is not necessarily transparent when electricity generation performance is not notably adversely affected. Examples of the material of the transparent electrode include the metal oxides, composite oxides, and metallic thin films described above, and the metal oxides and the composite oxides are preferable. The light transmittance of the upper electrode except a loss due to partial reflection at an optical interface is preferably 80% or more in consideration of the electricity generation efficiency of the organic photovoltaic device.

In such a case, it is preferable that the lower electrode formed in the substrate side has a light-transmitting property. In other words, use of a metal or alloy having a certain thickness as the upper electrode facilitates placement of the power collection line on the upper electrode and a reduction in resistance between the power collection line and the electrode.

Such materials of the lower electrode and the upper electrode may be used singly or may be used in any combination and ratio of two or more kinds thereof. Each of the lower electrode and/or the upper electrode may be single-layered or may be layered. In particular, it is preferable that the electrode having a light-transmitting property is formed of a metal oxide or a composite oxide among the above-described materials. The electrode may have a structure in which a thin metal layer is layered on such oxide layers as long as the light-transmitting property is not lost in order to improve conductivity.

In the present embodiment, a method for forming the lower electrode and the upper electrode is not restricted, and the lower electrode and the upper electrode can be formed by a known method in accordance with the material used. The lower electrode and the upper electrode can be formed by, for example, a dry process such as vacuum deposition or sputtering. The lower electrode and the upper electrode can also be formed by a wet process using a conductive ink. For example, a conductive polymer, a metal particle dispersion liquid, or the like can be used as the conductive ink. In the electrodes, two or more layers may be layered, and characteristics (electrical characteristics, wetting characteristics, and the like) based on surface treatment may be improved.

The thickness of each of the upper electrode and the lower electrode is not particularly restricted, and is typically 5 nm or more, preferably 10 nm or more, more preferably 20 nm or more, and still more preferably 50 nm or more. The thickness is typically 400 $\mu$m or less, preferably 10 $\mu$m or less, more preferably 1 $\mu$m or less, and still more preferably 500 nm or less. A case in which the thickness of each electrode is not less than the above-described lower limit results in a reduction in sheet resistance and enables sufficient conduction. A case in which the thickness is not more than the above-described upper limit enables flexibility to be maintained. It is necessary to select a film thickness enabling light transmittance and sheet resistance to be compatible with each other when such an electrode is a transparent electrode.

The sheet resistance of such an electrode is not particularly restricted, and is typically 1 $\Omega$/sq or more, and 1000 $\Omega$/sq or less, preferably 500 $\Omega$/sq or less, and still more preferably 100 $\Omega$/sq or less.

1.2.3.3 Photoelectric Conversion Layer

The photoelectric conversion layer of the organic photovoltaic device is formed so that the photoelectric conversion layer includes an organic semiconductor compound. The photoelectric conversion layer typically contains a p-type semiconductor compound and an n-type semiconductor compound. The p-type or the n-type determines which of a hole and an electron contributes to electrical conduction depending on the electronic, doping, and trapping states of a material. Accordingly, the p-type and the n-type may be unable to be necessarily definitely classified, and the same substance exhibits both characteristics of the p-type and the n-type. When the photoelectric conversion layer includes a p-type semiconductor compound and an n-type semiconductor compound, it is preferable that at least the p-type semiconductor compound is an organic semiconductor compound, and it is preferable that both the p-type semiconductor compound and the n-type semiconductor compound are organic semiconductor compounds.

Specific examples of the structure of the photoelectric conversion layer include a bulk heterojunction type structure including a layer (i-layer) in which a p-type semiconductor and an n-type semiconductor are phase-separated, a stacked type (hetero p-n junction type) structure in which a layer (p-layer) including a p-type semiconductor and a layer (n-layer) including an n-type semiconductor have an interface, a Schottky type structure including only one of p-type semiconductor and n-type semiconductor layers, and combinations thereof. Among them, a bulk heterojunction type structure or a combination (p-i-n junction type structure) of bulk heterojunction type and stacked type structures is preferred because of exhibiting high performance.

Examples of p-type semiconductors include p-type high-molecular organic semiconductor compounds and p-type low-molecular organic semiconductor compounds.

The p-type high-molecular organic semiconductor compounds are not particularly limited. Examples thereof include: conjugated polymer semiconductors such as polythiophene, polyfluorene, polyphenylenevinylene, polythienylenevinylene, polyacetylene, and polyaniline; and polymer semiconductors such as oligothiophene in which an alkyl group or another substituent is substituted. Examples thereof also include semiconducting polymers in which two or more monomer units are copolymerized. For example, polymers and derivatives thereof described in known literatures such as Handbook of Conducting Polymers, 3rd Ed. (two volumes in all), 2007, Materials Science and Engineering, 2001, 32, 1-40, Pure Appl. Chem. 2002, 74, 2031-3044, Handbook of THIOPHENE-BASED MATERIALS (two volumes in all), 2009, International Publication No. WO 2011/016430, International Publication No. WO 2013/180243, and Japanese Patent Laid-Open No. 2012-191194, and polymers which can be synthesized by combinations of described monomers can be used as such conjugated polymers. Such a high-molecular organic semiconductor compound which is used as the p-type semiconductor compound may be one kind of a compound or a mixture of plural kinds of compounds.

Such a p-type low-molecular organic semiconductor compound is not particularly restricted as long as being able to function as a p-type semiconductor material. Specific examples thereof include: condensed aromatic hydrocarbons such as naphthacene, pentacene, and pyrene; oligothiophenes containing four or more thiophene rings such as α-sexithiophene; compounds which contain at least one or more of thiophene ring, benzene ring, fluorene ring, naphthalene ring, anthracene ring, thiazole ring, thiadiazole ring, and benzothiazole ring, and in which four or more rings in total are linked; and macrocyclic compounds such as phthalocyanine compounds such as phthalocyanine, copper phthalocyanine, and zinc phthalocyanine, and metal complexes thereof, and porphyrin compounds such as tetrabenzoporphyrin, tetrabenzo copper porphyrin, and tetrabenzo zinc porphyrin, and metal complexes thereof. Preferred examples thereof include phthalocyanine compounds and metal complexes thereof, and porphyrin compounds and metal complexes thereof. Both the upper and lower limits of the molecular weight of the low-molecular organic semiconductor compound are not particularly restricted. The molecular weight is typically 5000 or less, and preferably 2000 or less, and typically 100 or more, and preferably 200 or more. When the p-type semiconductor layer is formed by coating, a low-molecular organic semiconductor compound precursor can be converted into a low-molecular organic semiconductor compound after coating with the low-molecular organic semiconductor compound precursor. A method using the low-molecular organic semiconductor compound precursor is more preferred in view of allowing a film to be more easily formed by coating. The low-molecular organic semiconductor compound precursor is a compound of which the chemical structure is changed, and which is converted into a low-molecular organic semiconductor compound, for example, by the application of an external stimulus such as heating or light irradiation. The low molecular organic semiconductor compound precursor is preferred in view of having excellent film formation properties.

The n-type semiconductor is not particularly restricted. Specific examples thereof include: fullerene; fullerene compounds; quinolinol derivative metal complexes represented by 8-hydroxyquinoline aluminum; naphthalene tetracarboxylic anhydrides; condensed ring tetracarboxylic diimides such as naphthalene tetracarboxylic diimide and perylene tetracarboxylic diimide; total fluorides of condensed polycyclic aromatic hydrocarbons such as perylene diimide derivatives, terpyridine metal complexes, tropolone metal complexes, flavonol metal complexes, perinone derivatives, benzimidazole derivatives, benzoxazole derivatives, thiazole derivatives, benzothiazole derivatives, benzothiadiazole derivatives, oxadiazole derivatives, thiadiazole derivatives, triazole derivatives, aldazine derivatives, bisstyryl derivatives, pyrazine derivatives, phenanthroline derivatives, quinoxaline derivatives, benzoquinoline derivatives, bipyridine derivatives, borane derivatives, anthracene, pyrene, naphthacene, and pentacene; and single-walled carbon nanotubes.

Among them, the n-type semiconductor compound is preferably a fullerene compound, a borane derivative, a thiazole derivative, a benzothiazole derivative, a benzothiadiazole derivative, N-alkyl-substituted naphthalene tetracarboxylic diimide, or an N-alkyl-substituted perylene diimide derivative, and more preferably a fullerene compound, an N-alkyl-substituted perylene diimide derivative, or N-alkyl-substituted naphthalene tetracarboxylic diimide. Among the above, one kind of a compound may be used, or a mixture of plural kinds of compounds may be used. Examples of the n-type semiconductor also include n-type polymeric semiconductors.

Such n-type semiconductor compounds or such p-type semiconductor compounds may be used singly or may be used in any combination and ratio of two or more kinds thereof.

A method for producing the photoelectric conversion layer is not particularly restricted, and is preferably a coating method, and especially preferably a wet coating method. Any method can be used as the coating method, and examples thereof include a spin coating method, a reverse roll coating method, a gravure coating method, a kiss coating method, a roll brushing method, a spray coating method, an air-knife coating method, a wire-bar bar coating method, a pipe doctor method, an impregnation/coating method, and a curtain coating method. When the photoelectric conversion layer is formed by a roll-to-roll method, it is preferable that a wet coating method is applied because of enabling the photoelectric conversion layer to be rapidly formed in large quantity at a low cost by a simple apparatus. When the wet coating method is performed, it is preferable to choose a solvent in which a layer to be coated is not dissolved.

The film thickness of the photoelectric conversion layer is not particularly restricted, and is set typically at 50 nm or more, preferably 100 nm or more, in order to increase photocurrent, and set typically at 1000 nm or less, 500 nm or less, in order to reduce series resistance.

1.2.3.4 Buffer Layers

In the organic photovoltaic device in the present embodiment, buffer layers may be included between the lower electrode and the photoelectric conversion layer and/or between the upper electrode and the photoelectric conversion layer. The buffer layers refer to an electron extraction layer and/or a hole extraction layer. The buffer layers are not essential in the organic photovoltaic device, and only one of the electron extraction layer and the hole extraction layer may be included. The electron extraction layer preferably exists between the cathode and the photoelectric conversion layer, and the hole extraction layer preferably exists between the anode and the photoelectric conversion layer.

Specifically, the organic photovoltaic device preferably includes the lower electrode, the electron extraction layer, the photoelectric conversion layer, the hole extraction layer, and the upper electrode in the order mentioned when the upper electrode is the anode, the lower electrode is the cathode, and the organic photovoltaic device includes both the electron extraction layer and the hole extraction layer as the buffer layers. When the organic photovoltaic device includes the electron extraction layer but does not include the hole extraction layer, the organic photovoltaic device preferably includes the lower electrode, the electron extraction layer, the photoelectric conversion layer, and the upper electrode in the order mentioned. Similarly, when the organic photovoltaic device includes the hole extraction layer but does not include the electron extraction layer, the organic photovoltaic device preferably includes the lower electrode, the photoelectric conversion layer, the hole extraction layer, and the upper electrode in the order mentioned.

At least one of the electron extraction layer and the hole extraction layer may be formed of plural different layers.

[Electron Extraction Layer]

The material of the electron extraction layer is not particularly restricted as long as being a material that improves the efficiency of extracting electrons from the photoelectric conversion layer to the cathode, and examples thereof include inorganic compounds and organic compounds.

Examples of the materials of the inorganic compounds include: salts of alkali metals such as Li, Na, K, and Cs; and n-type semiconductor oxides such as titanium oxide ($TiO_x$) and zinc oxide (ZnO). Especially, fluoride salts such as LiF, NaF, KF, and CsF are preferred as such salts of the alkali metals, and zinc oxide (ZnO) is preferred as such an n-type semiconductor oxide. The mechanism of action of such a material is unclear, but is considered to be a reduction in the work function of a cathode and an increase in voltage applied into the organic photovoltaic device in a case in which the material is combined with a cathode formed of Al or the like.

Examples of the materials of the organic compounds include: phosphine compounds having a double bond between a phosphorus atom and a Group 16 device, such as triarylphosphine oxide compounds; phenanthrene compounds which may have a substituent, and in which the 1-position and the 10-position may be replaced by hetero atoms, such as bathocuproine (BCP) and bathophenanthrene (Bphen); boron compounds such as triaryl boron; organic metal oxides such as (8-hydroxyquinolinato)aluminum (Alq3); compounds which may have a substituent and have one or two ring structures, such as oxadiazole compounds and benzimidazole compounds; and aromatic compounds having a condensed dicarboxylic acid structure, such as dicarboxylic anhydrides such as naphthalene tetracarboxylic anhydride (NTCDA) and perylene tetracarboxylic anhydride (PTCDA).

The thickness of the electron extraction layer is not particularly limited, and is typically 0.01 nm or more, preferably 0.1 nm or more, and more preferably 0.5 nm or more. The thickness is typically 400 nm or less, and preferably 200 nm or less. A case in which the thickness of the electron extraction layer is not less than the above-described lower limit allows a function as a buffer material to be performed. A case in which the thickness of the electron extraction layer is not more than the above-described upper limit facilitates extraction of electrons and enables photoelectric conversion efficiency to be improved.

A method for forming the electron extraction layer is not restricted. For example, in the case of using a material having sublimability, the electron extraction layer can be formed by a vacuum deposition method or the like. Specifically, for example, in the case of using an alkali metal salt as the material of the electron extraction layer, the electron extraction layer can be formed using a vacuum film formation method such as vacuum deposition or sputtering. Especially, it is desirable to form the electron extraction layer by vacuum deposition by resistance heating. Damage to another layer such as the photoelectric conversion layer can be reduced by using vacuum deposition.

For example, in the case of using a material soluble in a solvent, the electron extraction layer can be formed by a wet coating method such as a spin coating method, a reverse roll coating method, a gravure coating method, a kiss coating method, a roll brushing method, a spray coating method, an air-knife coating method, a wire-bar bar coating method, a pipe doctor method, an impregnation/coating method, or a curtain coating method, or the like, like the above-described method for producing the photoelectric conversion layer.

With regard to the metal oxides of the n-type semiconductor, it is desirable to form the electron extraction layer using a coating method although a vacuum film formation method such as a sputtering method can also be used, for example, in the case of using zinc oxide ZnO as the material of the electron extraction layer. For example, the electron extraction layer including zinc oxide can be formed according to a sol-gel method described in Sol-Gel Science, written by C. J. Brinker, G. W. Scherer, Academic Press (1990). The thickness in this case is typically 0.1 nm or more, preferably 2 nm or more, and more preferably 5 nm or more, and typically 1 μm or less, preferably 100 nm or less, and more preferably 50 nm or less. The excessively small thickness of the electron extraction layer results in the insufficient effect of improving electronic extraction efficiency, while the excessively large thickness tends to allow the electron extraction layer to act as a series resistance component, thereby deteriorating the characteristics of the device.

When the electron extraction layer is formed by a roll-to-roll method, it is preferable that a wet coating method is applied because of enabling the electron extraction layer to be rapidly formed in large quantity at a low cost by a simple apparatus. When the wet coating method is performed, it is preferable to choose a solvent in which a layer to be coated is not dissolved.

[Hole Extraction Layer]

The material of the hole extraction layer is not particularly limited as long as being a material that can improve the efficiency of extracting holes from the photoelectric conversion layer to the anode. Specific examples thereof include: conductive polymers obtained by doping polythiophene, polypyrrole, polyacetylene, triphenylene diamine, polyaniline, and the like with sulfonic acid and/or iodine, and the like; conductive organic compounds such as polythiophene derivatives having sulfonyl group as a substituent, and arylamine; metal oxides such as copper oxide, nickel oxide, manganese oxide, molybdenum oxide, vanadium oxide, and tungsten oxide; Nafion; and a p-type semiconductor described later. Among them, a conductive polymer doped with sulfonic acid is preferred, and (3,4-ethylenedioxythiophene)poly(styrenesulfonate) (PEDOT:PSS) obtained by doping a polythiophene derivative with polystyrene sulfonate is more preferred. A thin film of a metal such as gold, indium, silver, or palladium, or the like can also be used. The thin film of a metal or the like may be formed individually, or may be used in combination with the organic materials described above.

The thickness of the hole extraction layer is not particularly limited, and is typically 0.2 nm or more. The thickness is typically 400 nm or less, and preferably 200 nm or less. A case in which the thickness of the hole extraction layer is 0.2 nm or more allows a function as a buffer material to be performed. A case in which the thickness of the hole extraction layer is 400 nm or less facilitates extraction of holes and enables photoelectric conversion efficiency to be improved.

A method for forming the hole extraction layer is not restricted. For example, in the case of using a material having sublimability, the hole extraction layer can be formed by a vacuum deposition method or the like. For example, in the case of using a material soluble in a solvent, the hole extraction layer can be formed by a wet coating method such as a spin coating method, a reverse roll coating method, a gravure coating method, a kiss coating method, a roll brushing method, a spray coating method, an air-knife coating method, a wire-bar bar coating method, a pipe doctor method, an impregnation/coating method, or a curtain coating method. It is preferable to form the hole extraction layer by coating. In the case of using a semiconductor material in the hole extraction layer, a precursor may be converted into a semiconductor compound after formation of the layer using the precursor, like a low-molecular organic semiconductor compound in an organic photoelectric conversion layer described later.

Especially, in the case of using PEDOT:PSS as the material of the hole extraction layer, it is preferable to form the hole extraction layer by a method of coating with a dispersion liquid. Examples of the dispersion liquid for PEDOT:PSS include CLEVIOS™ series manufactured by Heraeus, and ORGACON™ series manufactured by Agfa Specialty Products.

When the hole extraction layer is formed by a roll-to-roll method, it is preferable that a wet coating method is applied because of enabling the hole extraction layer to be rapidly formed in large quantity at a low cost by a simple apparatus. When the wet coating method is performed, it is preferable to choose a solvent in which a layer to be coated is not dissolved.

1.2.4 Power Collection Line

A common thin film photovoltaic module typically includes a power collection line for extracting electricity from a thin film photovoltaic device. A metal, an alloy, or the like is often used as the material of the power collection line. Especially, it is preferable to use copper, aluminum, silver, gold, nickel, or the like having a low resistivity. Especially, copper and aluminum are particularly preferred because of being inexpensive. For prevention of rust, the periphery of the power collection line may be plated with tin, silver, or the like, or the surface of the power collection line may be coated with resin or the like, or may be laminated with a film. Examples of the shape of the power collection line include rectangular wire, foil, flat sheet, and wire shapes, and it is preferable to use the power collection line having a rectangular wire, foil, or flat sheet shape because of, e.g., securing an adhesive area.

Herein, "foil" refers to a foil having a thickness of less than 100 $\mu$m, and "sheet" refers to a sheet having thickness of 100 $\mu$m or more. "Rectangular wire" refers to a rectangular wire obtained by rolling a wire having a circular cross section, thereby allowing the cross-sectional shape of the wire to be quadrangular.

The power collection line is not particularly limited as long as having conductivity. The power collection line of which the electric resistance value is lower than the electric resistance values of the upper and lower electrodes to which the power collection line is connected is preferred. In particular, it is preferable to reduce the electric resistance value of the power collection line by allowing the thickness of the power collection line to be larger than the thicknesses of the upper and lower electrodes. The thickness of the power collection line is preferably 5 $\mu$m or more, and more preferably 10 $\mu$m or more. The thickness is preferably 2 mm or less, more preferably 1 mm or less, still more preferably 300 $\mu$m or less, and particularly preferably 200 $\mu$m or less. A case in which the thickness is smaller than the above-described range results in the increased resistance value of the power collection line and may make it impossible to efficiently extract a generated power to the outside. A case in which the thickness is larger than the above-described range may cause problems such as an increase in the weight of the thin film photovoltaic module and the deterioration of flexibility, the easy generation of recesses and projections on a module surface, and an increase in production cost.

The width of the power collection line is preferably 0.5 mm or more, more preferably 1 mm or more, and particularly preferably 2 mm or more. The width of the power collection line is preferably 50 mm or less, more preferably 20 mm or less, and particularly preferably 10 mm or less. A case in which the width of the power collection line is less than the above-described range results in the increased electric resistance value of the power collection line and may make it impossible to efficiently extract a generated power. In addition, the case results in a decrease in the mechanical strength of the power collection line and may cause rupture and the like. A case in which the width of the power collection line is more than the above-described range results in a decrease in opening ratio in the entire module and may lead to a decrease in the electric-generating capacity of the module.

The shape of the power collection line may be allowed to be an embossed shape. The embossed shape means a shape formed by, e.g., being embossed with any pattern with recesses and projections. By allowing the power collection line to have an embossed shape, conductivity is enhanced because part of the recesses and projections of the embossed shape can come directly in contact with or can be very close to an electrode even if an adhesive layer is used.

An embossment depth is typically 5 to 100 μm, and preferably 10 to 50 μm. The embossment depth means the height of a projection formed by embossment, and is specifically a value obtained by subtracting the thickness of the power collection line from a thickness including the projection. Such an embossment depth is preferred because the projections of the embossment can come directly in contact with the electrodes.

The power collection line is connected to the electrodes through a conductive adhesive layer. As a conductive adhesive component placed in the electrode of a photovoltaic, a thermosetting composition including conductive particles, a thermoplastic plastic material including conductive particles, solder, metallic paste, or the like is known, and a known conductive adhesive layer can be used.

In the present embodiment, the gas barrier layer is layered so that the entire surface of the sealing layer is covered with the gas barrier layer and the gas barrier layer is larger than the thin film photovoltaic device. Specifically, for preventing degradation due to water or oxygen and for maintaining the performance of the photovoltaic device for a long period, it is preferable to place an end face of the gas barrier layer outside an end face of the device substrate so that the distance between the end face of the gas barrier layer and the end face of the device substrate is 5 mm or more.

In the present embodiment, it is preferable that in the case of using the organic photovoltaic device as the thin film photovoltaic device, the thickness x (μm) of the organic photovoltaic module in the center of a power collection line placement region in the width direction of the power collection line and the thickness y (μm) of the organic photovoltaic module at a position 5 mm outside from the peripheral edge of the organic photovoltaic device satisfy the following expression (I). A description will be given below with reference to the drawings.

$$(x - y) \leq 90 \quad (I)$$

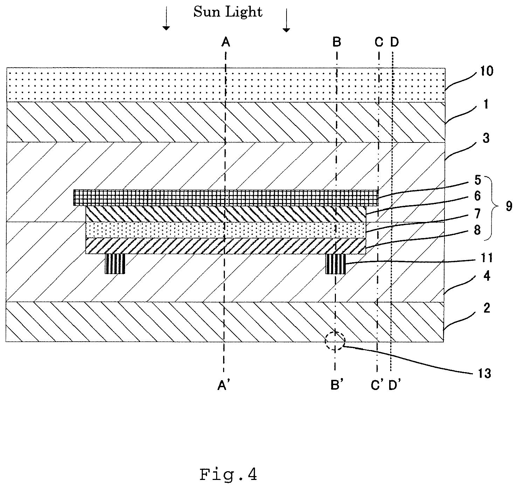

In Figure 4, the power collection line placement region in the present embodiment is a region on a surface of the organic photovoltaic module, in which a face horizontal to the thickness direction of the organic photovoltaic module that comes in contact with both right and left ends of the power collection line 11, i.e., the edges of the power collection line is surrounded by a line intersecting a surface of the organic photovoltaic module. The region is a region indicated by a chained line 13. The thickness x (μm) of the organic photovoltaic module in the center of the power collection line placement region 13 in the width direction of the power collection line is specifically, for example, the thickness of the organic photovoltaic module in the position of the alternate long and short dash line B-B' in Figure 4. The thickness y (μm) of the thin film photovoltaic module at the position 5 mm outside from the peripheral edge of the organic photovoltaic device is the thickness of the position 5 mm outside from the end face of the organic photovoltaic device to the end face of the organic photovoltaic module, indicated by the two-dot chain line C-C' in the figure. The thickness is the thickness of the organic photovoltaic module at the position of the dotted line D-D' in Figure 4. The chained line A-A' in the figure indicates the center of the organic photovoltaic module.

The thickness of the organic photovoltaic module is the shortest distance between the surfaces of the organic photovoltaic module in the second gas barrier layer side and the first gas barrier layer side, respectively, with respect to the organic photovoltaic device. The thickness typically means the length of the organic thin film sun module in the normal direction with respect to the surface in the second gas barrier layer side. The thickness of the organic photovoltaic module can be measured using, for example, a contact thickness gauge (KG601A, manufactured by ANRITSU CORPORATION).

In the present embodiment, the above-described expression (I) defines a range in which water and bubbles are easily removed from between the organic photovoltaic module and a construction object when the organic photovoltaic module is pasted on the construction object by wet pasting.

When a wind film is pasted on a construction object such as glass, it is necessary to bring the film and the glass into intimate contact with each other by running in turn a squeegee while uniformly applying pressure from the central portion of a film surface to the outside in order to remove water and bubbles existing between the wind film and the glass. In the present embodiment, a level difference can occur in the surface of the organic photovoltaic module due to the sealed power collection line and the sealed organic photovoltaic device. When a level difference exists in the surface of the organic photovoltaic module, the pressure of the squeegee becomes weak, it is difficult to uniformly apply pressure to the organic photovoltaic module, and it is impossible to remove water and bubbles, in the region of the level difference particularly in the case of shifting the squeegee from the site having the large thickness to the site having the small thickness of the organic photovoltaic module.

The above-described expression (I) defines the upper limit of the difference between the thickness x ($\mu$m) and thickness y ($\mu$m) of the thickest and thinnest sites of the organic photovoltaic module, respectively. In other words, in the organic photovoltaic module according to the configuration of the present embodiment, the center (corresponding to the x) of the power collection line placement region in the width direction of the power collection line is defined as the thickest location of the organic photovoltaic module, and the position (corresponding to the y) that is 5 mm from the peripheral edge of the organic photovoltaic device to a module end direction is typically defined as the thinnest location of the organic photovoltaic module.

In the present embodiment, (x - y) ($\mu$m) is preferably 90 or less, more preferably 85 or less, and still more preferably 80 or less. The lower limit thereof is not limited, and is typically 0.5 or more, preferably 1 or more, more preferably 3 or more, and more preferably 5 or more.

The storage moduli of the first sealing layer and the second sealing layer at 25°C and a frequency of 10 Hz are not particularly restricted. A case in which the storage modulus of such a sealing layer is too low may make it impossible to sufficiently remove water and bubbles in the case of squeegeeing. Therefore, the storage moduli of the first sealing layer and the second sealing layer at 25°C and a frequency of 10 Hz are preferably $1 \times 10^6$ or more, still more preferably $5 \times 10^6$ Pa or more, and particularly preferably $1 \times 10^7$ or more. The storage moduli of the first sealing layer and the second sealing layer at 25°C and a frequency of 10 Hz are preferably set at $6 \times 10^9$ or less, and particularly preferably at $2 \times 10^9$ or less in order to secure flexibility.

When the thickness of the organic photovoltaic module is 900 $\mu$m or less, a problem of a level difference tends to noticeably occur. Therefore, the present invention is allowed to be more effective by allowing (x - y) ($\mu$m) to be in the above-described range when the thickness of the organic photovoltaic module is 900 $\mu$m or less. Especially, the present invention is still more effective when the thickness of the organic photovoltaic module 700 $\mu$ or less, and the present invention is particularly effective when the thickness of the organic photovoltaic module is 500 $\mu$m or less. However, since the organic photovoltaic module is prone to be bent when the thickness of the organic photovoltaic module is too small, the thickness of the organic photovoltaic module is typically 100 $\mu$m or more.

The case of being not more than the above-described upper limit enables pressure to be uniformly applied to a level difference portion on the surface of the organic photovoltaic module when the squeegee is run in turn across the surface of the organic photovoltaic module while uniformly applying pressure to bring the organic photovoltaic module into intimate contact with the construction object, and enables water and bubbles between the organic photovoltaic module and the glass which is the construction object to be efficiently removed. The case of being not less than the above-described lower limit causes the increased number of the options of the kind of the power collection line used in the organic photovoltaic module. When voltage and/or current extracted from the organic photovoltaic device is increased, it is necessary to increase the thickness of the power collection line, and therefore, the degree of freedom of design of the organic photovoltaic module can be increased by increasing the options of the power collection line. In addition, such a case is preferred because of increasing the degree of freedom of layering conditions in the case of producing the organic photovoltaic module. Further, the degree of freedom of arrangement of the organic photovoltaic device in the organic photovoltaic module can also be increased.

The value of (x - y) ($\mu$m) can be controlled by, for example, setting the thicknesses of the sealing layer, the power collection line, and/or the organic photovoltaic device, and adjusting heat and/or pressure applied under the layering conditions of the organic photovoltaic module. The case of being not more than the above-described upper limit can be achieved by, for example, allowing the thickness of the second sealing layer to be larger than the thickness of the power collection line connected to the organic photovoltaic device, or allowing the sum of the thicknesses of the first sealing layer and the second sealing layer to be more than the sum of the thicknesses of the organic photovoltaic device and the power collection line.

The ranges of x ($\mu$m) and y ($\mu$m) are not limited, and x ($\mu$m) is preferably 300 or more, more preferably 330 or more, still more preferably 340 or more, and most preferably 350 or more. The upper limit thereof is not limited, and is typically 2000 or less.

A case in which x ($\mu$m) is not less than the above-described lower limit allows (x - y) ($\mu$m) to be easily decreased, enables pressure to be uniformly applied to the organic photovoltaic module in squeegee construction, and allows water and bubbles between the organic photovoltaic module and the glass which is the construction object to be easily removed.

It is preferable that y ($\mu$m) is 230 or more, still more preferably 280 or more, and most preferably 320 or more. The number of large recesses in the organic photovoltaic module is decreased in the region that is 5 mm or less from the peripheral edge of the organic photovoltaic device to the module end direction, pressure can be uniformly applied in squeegee construction, and water and bubbles between the organic photovoltaic module and the construction object can be removed. For example, by allowing the thicknesses of the first gas barrier layer and the second gas barrier layer to be larger than the sum of the thicknesses of the organic photovoltaic device and the power collection line, y ($\mu$m) can be controlled.

1.2.5 Other Layers

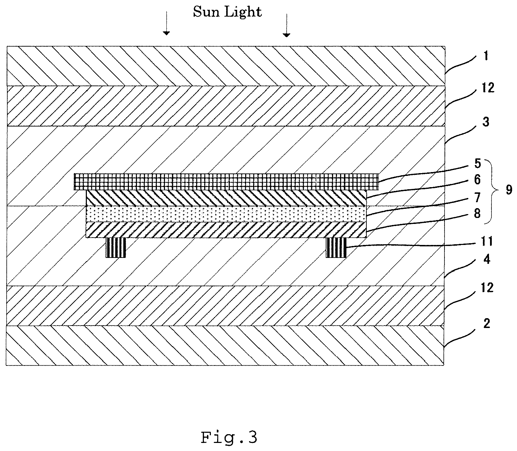

The organic photovoltaic module according to the present invention may include configuration members other than the above. For example, a protective layer, a UV-cut layer, a getter material layer, and the like may be included on a surface of the gas barrier layer, between the gas barrier layer and the sealing layer, and between the gas barrier layer and the adhesive layer. These layers may also be used as gas barrier layers. A configuration example of the organic photovoltaic module including a getter layer between the gas barrier layer and the sealing layer is illustrated in Figure 3. Figure 3 illustrates a configuration in which a power collection line 11 is placed on an upper electrode.

(Getter Layer)

The getter layer is a layer that absorbs water and/or oxygen. Among the components of the thin film photovoltaic device, there may be some which are degraded by water, and there may be some which are degraded by oxygen, as described above. Thus, the thin film photovoltaic device and the like are protected from water and/or oxygen by covering the thin film photovoltaic device with the getter layer, whereby electricity generation performance is highly maintained.

In such a case, a water getter layer is different from such a gas barrier layer as described above, and is not inhibited from transmitting water but absorbs water. Use of the layer that absorbs water enables the getter layer to catch water that slightly infiltrates a space formed by the gas barrier layer, thereby eliminating the influence of the water on the thin film photovoltaic device, when the thin film photovoltaic device is covered with the gas barrier layer and the like.

The degree of the water absorption capacity of the getter layer is typically 0.1 mg/cm$^2$ or more, preferably 0.5 mg/cm$^2$ or more, and more preferably 1 mg/cm$^2$ or more. The higher numerical value thereof results in the higher water absorption capacity, thereby enabling the degradation of the thin film photovoltaic device to be more greatly suppressed. The upper limit thereof is not restricted, and is typically 10 mg/cm$^2$ or less.

The absorption of oxygen by the getter layer enables the getter layer to catch oxygen that slightly infiltrates the space formed by the gas barrier layer, thereby eliminating the influence of the oxygen on the thin film photovoltaic device, when the thin film photovoltaic device is covered with the gas barrier layer and the like.

Further, the getter layer preferably transmits visible light from the viewpoint of preventing the thin film photovoltaic device from being inhibited from absorbing light. For example, the light transmittance of visible light (wavelengths of 360 to 830 nm) is typically 60% or more, preferably 70% or more, more preferably 75% or more, still more preferably 80% or more, especially preferably 85% or more, notably preferably 90% or more, particularly preferably 95% or more, and especially particularly preferably 97% or more. This is because sunlight is converted into more electric energy.

It is preferable that the getter layer also has resistance to heat because the organic photovoltaic module is often heated by receiving light. From this viewpoint, the melting point of the component material of the getter layer is typically 100°C or more, preferably 120°C or more, more preferably 130°C or more, and typically 350°C or less, preferably 320°C or less, and more preferably 300°C or less. By raising the melting point, a possibility that the getter layer melts and degrades can be reduced when the organic photovoltaic module is used.

A material forming the getter layer is arbitrary as long as being able to absorb water and/or oxygen. Examples of the material include, as substances that absorb water: alkali metals, alkaline-earth metals, and oxides of alkaline-earth metals; hydroxides of alkali metals and alkaline-earth metals; silica gel, zeolite-based compounds, and sulfates such as magnesium sulfate, sodium sulfate, and nickel sulfate; and organometallic compounds such as aluminum metal complexes and aluminum oxide octylate. Specific examples of the alkaline-earth metals include Ca, Sr, and Ba. Examples of the oxides of the alkaline-earth metals include CaO, SrO, and BaO. Additional examples thereof include Zr-Al-BaO and aluminum metal complexes. Specific examples of the trade names thereof include OleDry (manufactured by FUTABA CORPORATION).

Examples of the substances that absorb oxygen include activated carbon, silica gel, activated alumina, molecular sieves, magnesium oxide, and iron oxide. Examples thereof also include Fe, Mn, Zn, and inorganic salts such as sulfates, chloride salts, and nitrates of these metals.

The getter layer may be formed of one material or may be formed of two or more materials. The getter layer may also be formed of a single layer or may also be a layered body including two or more layers.

The thickness of the getter layer is not particularly defined, and is typically 5 $\mu$m or more, preferably 10 $\mu$m or

more, and more preferably 15 $\mu$m or more, and typically 200 $\mu$m or less, preferably 180 $\mu$m or less, and more preferably 150 $\mu$m or less. The larger thickness tends to result in an increase in mechanical strength while the smaller thickness tends to result in enhanced flexibility.

The storage modulus of the getter layer at 25°C and a frequency of 10 Hz is not particularly restricted, and is set preferably at $1.0 \times 10^6$ Pa or more, still more preferably at $5.0 \times 10^6$ Pa or more, and particularly preferably at $1.0 \times 10^7$ Pa or more in order to prevent the organic photovoltaic device from being broken due to the influence of the deformation of the getter layer in a case in which the getter layer receives external stress. The storage modulus of the getter layer at 25°C and a frequency of 10 Hz is preferably $5.0 \times 10^8$ Pa or less, still more preferably $3.0 \times 10^8$ Pa or less, and particularly preferably $1.0 \times 10^8$ Pa or less in order to impart a function as a buffer layer against bending stress applied to the first sealing layer and to prevent a layer from peeling off in the organic photovoltaic device when the photovoltaic module is bent.

A position at which the getter layer is formed is not restricted as long as the getter layer is formed in the space formed by the gas barrier layer. Both faces of the thin film photovoltaic device, specifically, the face in the light-receiving surface side (lower face in Figure 3) and the face opposite to the light-receiving surface side (upper face in Figure 3) are preferably covered with the getter layer. This is because the face of the light-receiving surface side thereof and the face opposite to the light-receiving surface side are often formed to have larger areas than the areas of the other faces in the organic photovoltaic module, and therefore, the infiltration of water and oxygen tends to occur through these faces. From this viewpoint, it is preferable to dispose the getter layer between the gas barrier layer and the thin film photovoltaic device.

The getter layer can be formed by any method depending on the kind of an absorbent or a drying agent. For example, a method of attaching a film, in which the absorbent or the drying agent is dispersed, with a pressure sensitive adhesive, a method of applying a solution of the absorbent or the drying agent by a spin coating method, an ink-jet method, a dispenser method, or the like, or the like may be used. A film formation method such as a vacuum deposition method or a sputtering method may also be used.

As the film for the absorbent or the drying agent, for example, a polyethylene resin, a polypropylene resin, a cyclopolyolefin resin, a polystyrene resin, an acrylonitrile-styrene copolymer (AS resin), an acrylonitrile-butadiene-styrene copolymer (ABS resin), a polyvinyl chloride resin, a fluorinated resin, a poly(meth)acrylic resin, a polycarbonate resin, or the like can be used. Especially, films of polyethylene resins, fluorinated resins, cyclopolyolefin resins, and polycarbonate resins are preferred. Such resins may be used singly or may be used in any combination and ratio of two or more kinds thereof.

(Protective Layer)

As described above, the organic photovoltaic module according to the present invention may include protective layers (surface protective layer and/or back surface protective layer).

Such a protective layer is a layer that protects the organic photovoltaic module from an environment in which the organic photovoltaic module is placed, such as a change in temperature, a change in humidity, light, wind, or rain. There is an advantage that the configuration material, particularly, the organic photovoltaic device of the organic photovoltaic module is protected, and high generating capacity can be obtained without degradation by covering a surface of the organic photovoltaic module with the protective layer.

It is preferable that the protective layer has performance preferable for a material for covering a surface of the organic photovoltaic module, such as weather resistance, heat resistance, transparency, water repellency, stain resistance, and mechanical strength, and has the property of maintaining the performance for a long period in outdoor exposure because the protective layer is located on the outermost layer of the organic photovoltaic module.

From the viewpoint of preventing light absorption from being inhibited, it is preferable that the protective layer transmits visible light when the protective layer is used in the light-receiving surface side of the organic photovoltaic device. For example, the light transmittance of visible light (wavelengths 360 to 830 nm) is typically 75% or more, preferably 80% or more, more preferably 85% or more, still more preferably 90% or more, especially preferably 95% or more, and particularly preferably 97% or more. This is because sunlight is converted into more electric energy.

As the protective layer, a protective layer having a low degree of cloudiness (haze) is preferred from the viewpoint of design quality such as a sense of unity with a construction object, or appearance. For example, a haze value in the case of using a D65 light source defined in JIS K 7136 is typically 10 or less, preferably 5 or less, more preferably 2 or less, and still more preferably 1 or less.

In contrast, it is not necessary that the protective layer in the side opposite to the light-receiving surface of the thin film photovoltaic device transmits visible light, and the protective layer may be opaque; however, when the protective layer is pasted on a transparent construction object such as a window glass, it is preferable that the protective layer has visible light transmittance and a degree of cloudiness similar to those of the light-receiving surface side of the thin film photovoltaic device.

It is preferable that the protective layer also has resistance to heat because the thin film photovoltaic device is often heated by receiving light. From this viewpoint, the melting point of the component material of the protective layer is typically 100°C or more, preferably 120°C or more, and more preferably 130°C or more, and typically 350°C or less, preferably 320°C or less, and more preferably 300°C or less. By raising the melting point, a possibility that the protective layer melts and degrades can be reduced when the thin film photovoltaic device is used.

A material forming the protective layer is arbitrary as long as being able to protect the organic photovoltaic module. Examples of the material include polyethylene resins, polypropylene resins, cyclic polyolefin resins, AS (acrylonitrile-styrene) resins, ABS (acrylonitrile-butadiene-styrene) resins, polyvinyl chloride resins, fluorinated resins, polyester resins such as polyethylene terephthalate and polyethylene naphthalate, phenolic resins, polyacrylic resins, polyamide resins such as various kinds of nylons, polyimide resins, polyamideimide resins, polyurethane resins, cellulosic resins, silicone-based resins, and polycarbonate resins.

Especially, preferred examples thereof include fluorinated resins, of which specific examples include polytetrafluoroethylene (PTFE), a 4-ethylene fluoride-perchloroalkoxy copolymer (PFA), a 4-ethylene fluoride-6-propylene fluoride copolymer (FEP), a 2-ethylene-4-ethylene fluoride copolymer (ETFE), a poly 3-fluorinated ethylene chloride (PCTFE), polyvinylidene fluoride (PVDF), and polyvinyl fluoride (PVF).

The protective layer may be formed of one material or may be formed of two or more materials. The protective layer may also be formed of a single-layer film or may also be a layered film including two or more films which are layered.

The thickness of the protection layer is not particularly defined, and is typically 10 $\mu$m or more, preferably 15 $\mu$m or more, more preferably 20 $\mu$m or more, still more preferably 30 $\mu$m or more, and particularly preferably 50 $\mu$m or more, and typically 200 $\mu$m or less, preferably 180 $\mu$m or less, and more preferably 150 $\mu$m or less. A case in which the thickness is not less than the above-described lower limit tends to result in an increase in the mechanical strength of the organic photovoltaic module, while a case in which the thickness is not more than the above-described upper limit tends to result in enhanced flexibility. Therefore, it is desirable to set the thickness in the above-described range as a range in which both of such advantages are achieved.

In order to improve adhesiveness with other films, surface treatment such as corona treatment or plasma treatment may be performed on the protective layer.

It is preferable to dispose the protective layer on the outermost side of the organic photovoltaic module, in order to protect device configuration members as many as possible.

The a protective layer may also be imparted with functions such as ultraviolet shielding, heat ray shielding, antifouling properties, hydrophilicity, hydrophobicity, anti-fogging properties, scrub resistance, conductivity, antireflection, antiglare properties, light diffusion, light scattering, wavelength conversion, and gas barrier properties. In particular, an organic photovoltaic preferably has the ultraviolet shielding function because the organic photovoltaic may be degraded due to ultraviolet light in sunlight.

As a method of imparting such a function, a layer having the function may be layered on the protective layer by forming a film by coating, or the like, or a material that exhibits the function may be incorporated into the protective layer by dissolution, dispersion, or the like.

A hard coat layer may be disposed on the protective layer in order to prevent flawing in handling of the organic photovoltaic module, to prevent flawing due to a squeegee in wet pasting on a construction object, and to improve the smoothness of the protective layer.

As the hard coat layer, a conventionally known hard coat layer may be used, and examples of the hard coat layer include layers including ultraviolet curable resins; electron beam curable resins; alkoxysilane hydrolyzed condensed resins; melamine resins; acrylic resins such as (meth)acrylate-based alcohol-modified multifunctional compounds, trimethylolpropane (meth)acrylate, tripropylene glycol diacrylate, pentaerythritol triacrylate, and 1,6-hexanediol (meth)acrylate; and the like, but are not limited thereto. The hard coat layer preferably has a hardness, as a pencil hardness, of 2H or more, and still more preferably 3H or more. In addition, the film thickness thereof is preferably 1 to 10 $\mu$m. A case in which the film thickness is less than 1 $\mu$m may result in the insufficient effect of scratch resistance, while a case in which the film thickness is 10 $\mu$m or more may cause the protective layer to be curled due to the cure shrinkage of the hard coat layer.

(UV-Cut Layer)

As described above, the organic photovoltaic module according to the present invention may include the UV-cut layer.

The UV-cut layer is a layer that preventing transmission of ultraviolet light.

Among the components of the organic photovoltaic module, there are some which are degraded due to ultraviolet light. The gas barrier layer may be degraded due to ultraviolet light depending on the kind thereof. Thus, the thin film photovoltaic device and, as needed, the gas barrier layer can be protected from ultraviolet light, and electricity generation performance can be highly maintained, by disposing the UV-cut layer on the light receiving portion of the organic photovoltaic module, and covering the light-receiving surface of the thin film photovoltaic device with the UV-cut layer.

With regard to the degree of an ultraviolet transmission suppression ability required by the UV-cut layer, the transmittance of ultraviolet light (for example, a wavelength of 300 nm) is preferably 50% or less, more preferably 30% or less, and particularly preferably 10% or less.

It is preferable that the UV-cut layer transmits visible light from the viewpoint of preventing the thin film photovoltaic device from being inhibited from absorbing light. For example, the light transmittance of visible light (wavelengths of 360 to 830 nm) is preferably 80% or more, more preferably 90% or more, and particularly preferably 95% or more.

It is preferable that the UV-cut layer also has resistance to heat because the organic photovoltaic module is often heated by receiving light. From this viewpoint, the melting point of the component material of the UV-cut layer is typically 100°C or more, preferably 120°C or more, and more preferably 130°C or more. The melting point is typically 350°C or less, preferably 320°C or less, and more preferably 300°C or less. When the melting point is too low, the UV-cut layer may melt in use of the organic photovoltaic module.

It is preferable that the UV-cut layer has high flexibility and favorable adhesiveness with an adjacent layer, and can cut water vapor and oxygen.

A material forming the UV-cut layer is arbitrary as long as being able to decrease the intensity of ultraviolet light. Examples of the material include a layer formed by blending an epoxy, acrylic, urethane, or ester resin with an ultraviolet absorbent. The material may also be used as a layered body in which a layer obtained by dispersing or dissolving an ultraviolet absorbent in a resin (hereinafter referred to as "ultraviolet light absorption layer" as appropriate) is formed on a substrate film.

As the ultraviolet absorbent, for example, an ultraviolet absorbent based on salicylic acid, benzophenone, benzotriazole, or cyanoacrylate may be used. Especially, ultraviolet absorbents based on benzophenone and benzotriazole are preferred. Examples thereof include various aromatic organic compounds based on benzophenone and benzotriazole. Such ultraviolet absorbents may be used singly or may be used in any combination and ratio of two or more kinds thereof.

Specific examples of the products of the UV-cut layer include CUT ACE (MKV Platech Co., Ltd.).

The UV-cut layer may be formed of one material or may be formed of two or more materials. The UV-cut layer may be formed of a single-layer film or may be a layered body including two or more layers.

The thickness of the UV-cut layer is not particularly defined, and is typically 5 $\mu$m or more, preferably 10 $\mu$m or more, and more preferably 15 $\mu$m or more. The thickness is typically 200 $\mu$m or less, preferably 180 $\mu$m or less, and more preferably 150 $\mu$m or less. The larger thickness tends to result in an increase in ultraviolet absorption, while the smaller thickness tends to result in an increase in visible light transmittance.

The UV-cut layer may be disposed at a position covering at least part of the light-receiving surface of the thin film photovoltaic device. The UV-cut layer is preferably disposed at a position covering the whole of the light-receiving surface of the thin film photovoltaic device. However, the UV-cut layer may also be disposed at a position other than the position covering the light-receiving surface of the thin film photovoltaic device.

1.2.6 Adhesive Layer

The organic photovoltaic module according to the present embodiment preferably includes the adhesive layer for placement on a window glass. The adhesive layer is a layer that is located in the outermost layer of the organic photovoltaic module and that is for pasting the organic photovoltaic module on a construction object such as glass.

A known transparent pressure sensitive adhesive may be used as the adhesive layer. Examples thereof include acrylic pressure sensitive adhesives, polyester pressure sensitive adhesives, rubber pressure sensitive adhesives, silicone pressure sensitive adhesives, and polyurethane pressure sensitive adhesives. Especially, acrylic adhesives are preferred from the viewpoint of weather resistance and transparency.

The adhesive layer can be disposed on the outermost layer in the substrate side (light-receiving surface) or photoelectric conversion layer side (non-light-receiving surface) of the organic photovoltaic device of the organic photovoltaic module by a known method. It is preferable to dispose the adhesive layer on the outermost layer of the substrate side (light-receiving surface) of the organic photovoltaic device from the viewpoint of the electricity generation efficiency of the organic photovoltaic device.

The adhesive layer can be disposed on the outermost layer in the light-receiving surface or non-light-receiving surface side of the organic photovoltaic module by a known method. For example, the adhesive layer can be disposed by disposing an adhesive on release paper, dry laminating the adhesive on the outermost layer of the photovoltaic, and then removing the release paper.

The adhesive layer preferably has an adhesive strength and a tack strength sufficient for preventing glass from flying off when a window glass is broken. Specifically, the adhesive layer having a peel force of about 4.0 N/25 mm or more in the method described in JIS A 5759 can be used.

The thickness of the adhesive layer is not particularly limited, and is, for example, typically 20 $\mu$m or more,

preferably 30 $\mu$m or more, and more preferably 50 $\mu$m or more, and typically 500 $\mu$m, preferably 300 $\mu$m or less, and more preferably 200 $\mu$m or less. A case in which the thickness is not less than the above-described lower limit allows sufficient tackiness to be secured, while a case in which the thickness is not more than the above-described upper limit results in improvement in squeegeeing properties in placement on a construction object such as a window glass.

The organic photovoltaic module can be produced by a known method using the above-described configuration members and the like. For example, the organic photovoltaic module can be produced by the step of layering the gas barrier layer, the sealing layer, the thin film photovoltaic device, and the like, vacuum-aspirating such a layered body, and pressure-bonding the layered body by heating. The organic photovoltaic module may be produced by a batch method, or may be produced by a roll-to-roll method.

2. Method for Constructing Organic Photovoltaic Module

A method for constructing an organic photovoltaic module can be optionally selected depending on a construction object. The organic photovoltaic module of the present embodiment can be preferably used as a photovoltaic integrated wind film, and in this case, the organic photovoltaic module can be constructed by a method similar to a method for a common wind film.

Such a common wind film is pasted on glass by a method referred to as "wet pasting." In the method referred to as "wet pasting", water containing a slight amount of neutral detergent is sprayed on an adhesive face of a film and a face of glass by a sprayer, followed by temporarily pasting the film on the glass and then uniformly running a squeegee across a film surface in turn to bring the film and the glass into intimate contact with each other in order to paste the film on the glass. As a result, water and bubbles between the film and the glass are removed from an end of the film, and a favorable pasting face including neither folds nor bubbles can be obtained.

3. Uses

The organic photovoltaic module of the present invention can be pasted on an adherend such as the glass of the window, door, wall surface, ceiling, or the like of a building, a vehicle, or the like, or the glass of a partition or the like, and can be used. In this case, electricity is generated using sunlight, interior illumination, interior scattered light from sunlight, or the like, and power extracted from the power collection line can be charged using a known current and voltage conversion circuit, storage battery, or the like, and can be used. In particular, the organic photovoltaic module of the present invention has excellent durability and design quality for a photovoltaic integrated wind film.

Examples

The present invention will be specifically described with reference to examples. However, the present invention is not limited to the following examples.

<Evaluation Procedure A>

In the present examples, organic photovoltaic modules were evaluated by the following method.

[Storage Modulus of Sealing Layer]

A sealing layer was applied or layered, melted on a silicone mold release PET film, and then subjected to pressing and cooling processes to produce a sheet-shaped sample having a thickness of 200 $\mu$m. A strip-shaped sample having a length of 4 mm, a width of 60 mm, and a thickness of 200 $\mu$m was cut from the obtained sheet-shaped sample. The temperature dispersion of the produced strip-shaped sample was measured (the storage modulus (E') was measured under conditions of a vibration frequency of 10 Hz, a temperature-raising rate of 2°C/min, and a distortion of 0.05%, and at -100°C to 100°C) using a dynamic viscoelasticity measurement apparatus (RSAIII, manufactured by TA Instruments) to measure the storage modulus (E') at 25°C and a frequency of 10 Hz.

[Cut Surface after Trimming]

After the production of the organic photovoltaic module, the organic photovoltaic module was cut into a predetermined size using commonly used fabric shears. The cutting was performed at a position 5 mm or more apart from an end face of an device substrate between an end face of a gas barrier layer and the end face of the device substrate. An end of the module was observed and evaluated on the basis of the following criteria.

Good: No peeling of cut surface of end of organic photovoltaic module
Poor: Peeling of part or whole of cut surface of end of organic photovoltaic module

[Durability of Device (EL Light Emission)]

The produced organic photovoltaic module was wet-pasted by squeegee construction, and the EL light emission of a thin film photovoltaic device was evaluated using a photovoltaic EL test apparatus manufactured by ITES Co., Ltd. The evaluation criteria are as follows.

Good: No changes of initial EL light emission image of thin film photovoltaic device and EL light emission image after squeegeeing
Fair: Portion, damaged by squeegee pressure, of less than 5% with respect to initial area in comparison between initial EL light emission image of thin film photovoltaic device and EL light emission image after squeegeeing
Poor: Portion, damaged by squeegee pressure, of 5% or more with respect to initial area in comparison between initial EL light emission image of thin film photovoltaic device and EL light emission image after squeegeeing

[Bending Test]

The produced organic photovoltaic module was bent at a curvature radius of 85 mm, and the presence or absence of interlayer peeling in the organic photovoltaic module was confirmed. The evaluation criteria are as follows.

Good: No occurrence of interlayer peeling in organic photovoltaic module after bending of organic photovoltaic module
Poor: Occurrence of interlayer peeling in organic photovoltaic module after bending of organic photovoltaic module

<Example A1>

A thin film photovoltaic module having a layer configuration illustrated in the schematic cross-sectional view of Figure 2 was produced in the following procedure.

As pre-preparation before layering, a power collection line with a conductive thermoset resin composition (DT101C4 of 15 $\mu$m (epoxy-based conductive curable resin including nickel particles as conductive particles, curing temperature of 120°C), manufactured by Dexerials Corporation, + copper foil of 35 $\mu$m in thickness, 4 mm in width) was placed on the upper electrode of the organic photovoltaic devices of both ends of plural organic photovoltaic devices having a length of 150 mm and a width of 100 mm formed on a PEN substrate of 100 $\mu$m (the total of the thicknesses of the PEN substrate and the organic photovoltaic devices was 120 $\mu$m).

Further, a film 1 with a length of 300 mm and a width of 200 mm obtained by layering a butyl rubber pressure sensitive adhesive having a thickness of 40 $\mu$m (manufactured by Sumitomo 3M Limited) as a first sealing layer on a barrier film having a thickness of 60 $\mu$m (VIEW-BARRIER, VDK3DA, manufactured by Mitsubishi Plastics, Inc.) as a first gas barrier layer, and a film 2 with a length of 300 mm and a width of 200 mm obtained by layering a butyl rubber pressure sensitive adhesive having a thickness of 40 $\mu$m (manufactured by Sumitomo 3M Limited) as a second sealing layer on a barrier film having a thickness of 60 $\mu$m (VIEW-BARRIER, VDK3DA, manufactured by Mitsubishi Plastics, Inc.) as a second gas barrier layer were produced. Then, the organic photovoltaic devices formed on the PEN substrate, and a layered body in which the film 1 and the film 2 were stacked were put in a vacuum laminator (NLM-270x400, manufactured by NPC Incorporated) so that the order of the first gas barrier layer, the first sealing layer, the organic photovoltaic devices, an device substrate, the second sealing layer, and the second gas barrier layer was achieved. First, the interior of the laminator was maintained under reduced pressure for 30 minutes, the layered body was then maintained at 120°C for 5 minutes while being in a pressure bonding state at atmospheric pressure, and a commercially available acrylic pressure sensitive adhesive having a thickness of 120 $\mu$m was pasted on the second gas barrier layer by a roll laminator (MRS630A, manufactured by MCK) after cooling, to produce the organic photovoltaic module.

<Example A2>

An organic photovoltaic module was produced in the same manner as the manner of Example A1 except that an olefin resin having a thickness of 60 $\mu$m (Kuranbeter, M-2, manufactured by KURABO) was used as the first and second sealing layers.

<Example A3>

An organic photovoltaic module was produced in the same manner as the manner of Example A1 except that the thicknesses of the first and second sealing layers were set at 20 $\mu$m.

<Example A4>

An organic photovoltaic module was produced in the same manner as the manner of Example A1 except that the thicknesses of the first and second sealing layers were set at 60 $\mu$m.

<Example A5>

An organic photovoltaic module was produced in the same manner as the manner of Example A1 except that an ethylene-vinyl acetate copolymer (EVA) resin having a thickness of 50 $\mu$m (UFHCE40, manufactured by C.I. Kasei Company, Limited) was used as the first and second sealing layers.

<Example A6>

An organic photovoltaic module was produced in the same manner as the manner of Example A4 except that the second sealing layer was not used.

<Comparative Example A1>

An organic photovoltaic module was produced in the same manner as the manner of Example A1 except that an acrylic pressure sensitive adhesive having a thickness of 20 $\mu$m (SK-Dyne, manufactured by Soken Chemical & Engineering Co., Ltd., main agent 1811L/curing agent L-45, solid content blending ratio: 100/1) was used as the first and second sealing layers.

<Comparative Example A2>

An organic photovoltaic module was produced in the same manner as the manner of Example A2 except that an epoxy-based thermal curing adhesive having a thickness of 60 $\mu$m (16X134, manufactured by ThreeBond Holdings Co., Ltd.) was used as the first and second sealing layers.

<Comparative Example A3>

An organic photovoltaic module was produced in the same manner as the manner of Comparative Example A1 except that the thicknesses of the first and second sealing layers were set at 60 $\mu$m.

<Comparative Example A4>

An organic photovoltaic module was produced in the same manner as the manner of Example A1 except that an SEBS-based resin having a thickness of 50 $\mu$m (Tuftec H1221, manufactured by Asahi Kasei Chemicals Corp.) was used as the first and second sealing layers.

<Comparative Example A5>

An organic photovoltaic module was produced in the same manner as the manner of Example A1 except that a polyvinyl butyral resin having a thickness of 20 $\mu$m (S-LEC BH-6, manufactured by SEKISUI CHEMICAL CO., LTD.) was used as the first and second sealing layers.

<Comparative Example A6>

An organic photovoltaic module was produced in the same manner as the manner of Comparative Example A3 except that amorphous silicon was used as a photoelectric conversion layer.

<Comparative Example A7>

An organic photovoltaic module was produced in the same manner as the manner of Example A2 except that amorphous silicon was used as a photoelectric conversion layer.

<Comparative Example A8>

An organic photovoltaic module was produced in the same manner as the manner of Comparative Example A3 except that the second sealing layer was not used.

The evaluation results of the organic photovoltaic modules of Examples A1 to A6 and Comparative Examples A1 to A8 are listed in Table 1.

[Table 1]

Table 1

| | First Sealing Layer | | | Second Sealing Layer | Photoelectric Conversion Layer | Devicet Durability | Trimming | Bending Test |
|---|---|---|---|---|---|---|---|---|
| | Material | Film thickness [$\mu$m] | Storage Modulus [Pa] | Material | | | | |
| Example A1 | Butyl rubber pressure sensitive adhesive | 40 | $9.0\times10^7$ | The same as first sealing layer | Organic | Good | Good | Good |
| Example A2 | Olefin resin | 60 | $1.5\times10^7$ | The same as first sealing layer | Organic | Good | Good | Good |
| Example A3 | Butyl rubber pressure sensitive adhesive | 20 | $9.0\times10^7$ | The same as first sealing layer | Organic | Fair | Good | Good |
| Example A4 | Butyl rubber pressure sensitive adhesive | 60 | $9.0\times10^7$ | The same as first sealing layer | Organic | Good | Good | Good |
| Example A5 | EVA | 50 | $1.1\times10^7$ | The same as first sealing layer | Organic | Good | Good | Good |
| Example A6 | Butyl rubber pressure sensitive adhesive | 60 | $9.0\times10^7$ | Absent | Organic | Good | Good | Good |
| Comparative Example A1 | Acrylic pressure sensitive adhesive | 20 | $8.0\times10^5$ | The same as first sealing layer | Organic | Poor | Good | Good |
| Comparative Example A2 | Epoxy-based thermal curing adhesive | 60 | $1.0\times10^9$ | The same as first sealing layer | Organic | Good | Poor | Poor |
| Comparative Example A3 | Acrylic pressure sensitive adhesive | 60 | $8.0\times10^5$ | The same first sealing layer | Organic | Poor | Good | Good |

EP 3 276 695 A1

| | First Sealing Layer | | | Second Sealing Layer | Photoelectric Conversion Layer | | | |
| --- | --- | --- | --- | --- | --- | --- | --- | --- |
| | Material | Film thickness [μm] | Storage Modulus [Pa] | Material | | Devicet Durability | Trimming | Bending Test |
| Comparative Example A4 | SEBS-based resin | 50 | $3.5 \times 10^6$ | The same as first sealing layer | Organic | Poor | Good | Good |
| Comparative Example A5 | Polyvinyl butyral resin | 20 | $1.4 \times 10^9$ | The same as first sealing layer | Organic | Good | Poor | Poor |
| Comparative Example A6 | Acrylic pressure sensitive adhesive | 60 | $8.0 \times 10^5$ | The same as first sealing layer | a-Si | Good | Good | Good |
| Comparative Example A7 | Olefin resin | 60 | $1.5 \times 10^7$ | The same as first sealing layer | a-Si | Good | Good | Good |
| Comparative Example A8 | Acrylic pressure sensitive adhesive | 60 | $8.0 \times 10^5$ | Absent | Organic | Poor | Good | Good |

EP 3 276 695 A1

As can be seen from the results of Table 1, in each of the organic photovoltaic modules according to Comparative Example A1, Comparative Example A3, and Comparative Example A4, in which both of the storage moduli of the first sealing layer and the second sealing layer were less than $5 \times 10^6$ Pa, interlayer peeling occurred in the organic photovoltaic device after squeegee construction in wet pasting construction, and as a result, design quality was notably deteriorated. In each of the organic photovoltaic modules according to Comparative Examples A2 and A5 in which both of the storage moduli of the first sealing layer and the second sealing layer were more than $1 \times 10^8$ Pa, interlayer peeling also occurred in the organic photovoltaic device when the organic photovoltaic module was trimmed and when the organic photovoltaic module was bent, and the design quality of each of the organic photovoltaic modules was notably deteriorated like Comparative Examples A1, A3, and A4. In contrast, it is found that in each of the organic photovoltaic modules according to Examples A1 to A5 having the adequate storage moduli of the first sealing layer and the second sealing layer, interlayer peeling hardly occurred in the organic photovoltaic device in all of the cases of squeegeeing in wet pasting construction, trimming, and bending of the thin film photovoltaic module, and high design quality can be maintained. In Example A6 and Comparative Example A8 in which the second sealing layer was not used, similar results were also obtained. It is found that particularly in the case of the thin film photovoltaic module in which the photoelectric conversion layer was formed of amorphous silicon as described in Comparative Examples A6 and A7, it was important to use a sealing layer having an appropriate storage modulus as the first sealing layer when the organic photovoltaic device was used, because interlayer peeling in the thin film photovoltaic device due to the difference between the storage moduli did not occur. In addition, it was found that interlayer peeling in the organic photovoltaic device was able to be further suppressed in squeegeeing in wet pasting construction by allowing the film thickness of the first sealing layer to be an appropriate thickness in Examples A1 to A6.

<Evaluation Procedure B>

In the present examples, organic photovoltaic modules were evaluated by the following method.

[Method for Measuring Thickness]

The thickness x ($\mu$m) of an organic photovoltaic module in the center of a power collection line placement region in the width direction of a power collection line, and the thickness y ($\mu$m) of the organic photovoltaic module at a position 5 mm from the peripheral edge of the organic photovoltaic device were measured using a contact thickness gauge (KG601A, manufactured by ANRITSU CORPORATION), and the value of (x - y) ($\mu$m) was calculated.

[Method for Evaluating Bubbles after Squeegee Construction]

From the observation results of the organic photovoltaic modules, the organic photovoltaic modules were evaluated as "good", "fair", or "poor" on the basis of the following criteria.
The presence or absence of water and bubbles between the organic photovoltaic module and glass was observed from a position 1 m apart and a position 0.1 m apart after a lapse of 1 day or more after the production of the organic photovoltaic module. The evaluation criteria are as follows.

Good: Neither water nor bubbles can be viewed from a position 0.1 m apart.
Fair: Neither water nor bubbles can be viewed from a position 1 m apart.
Poor: Water and bubbles can be viewed from a position 1 m apart.

<Example B1>

An organic photovoltaic module having a configuration illustrated in Figure 2 was produced in the following procedure.
As pre-preparation before layering, a power collection line with a conductive thermoset resin composition (DT101C4 of 15 $\mu$m (epoxy-based conductive curable resin including nickel particles as conductive particles, curing temperature of 120°C), manufactured by Dexerials Corporation, + copper foil of 35 $\mu$m in thickness, 4 mm in width) was placed on the upper electrode of the organic photovoltaic devices of both ends of plural organic photovoltaic devices having a length of 150 mm and a width of 100 mm formed on a PEN substrate of 100 $\mu$m (the total of the thicknesses of the PEN substrate and the organic photovoltaic devices was 120 $\mu$m).
A film 1 with a length of 300 mm and a width of 200 mm obtained by layering a sealing material having a thickness of 40 $\mu$m (epoxy-based thermosetting resin, TB1651D, manufactured by ThreeBond Holdings Co., Ltd.) as a second sealing layer on a barrier film having a thickness of 60 $\mu$m (VIEW-BARRIER, VDK3DA, manufactured by Mitsubishi Plastics, Inc.) which was the material of a second gas barrier layer, and a film 2 with a length of 300 mm and a width of 200 mm obtained by layering a sealing material having a thickness of 40 µm (epoxy-based thermosetting resin, 16X134, manufactured by ThreeBond Holdings Co., Ltd.) as a first sealing layer on a barrier film having a thickness of 60 µm which was the same as the thickness of a first gas barrier layer (VIEW-BARRIER, VDK3DA, manufactured by Mitsubishi Plastics, Inc.) were produced. Then, the organic photovoltaic devices formed on the PEN substrate, and a layered body in which the film 1 and the film 2 were stacked were placed in a vacuum laminator (LM-50×50, manufactured by NPC Incorporated) so that the order of the first gas barrier layer, the first sealing layer, the organic photovoltaic devices, an device substrate, the second sealing layer, and the second gas barrier layer was achieved.

The interior of the vacuum laminator was maintained under reduced pressure for 14 minutes, and the layered body was then maintained at 140°C for 3 minutes while being in a pressure bonding state at atmospheric pressure. The layered body taken out from the vacuum laminator was heated in a hot air oven (manufactured by YOUGROP Co., Ltd.) at 120°C for 60 minutes, and cooled, and a commercially available acrylic pressure sensitive adhesive having a thickness of 120 µm was then pasted on a surface of the second gas barrier layer by a roll laminator (MRS630A, manufactured by MCK), to produce the organic photovoltaic module.

After 1% of aqueous surfactant solution was sprayed on an acrylic pressure sensitive adhesive, the organic photovoltaic module was pasted on float glass having a thickness of 3.2 mm on which 1% of aqueous surfactant solution was similarly sprayed, 1% of aqueous surfactant solution and bubbles between the acrylic pressure sensitive adhesive and the float glass were removed with a squeegee made of nylon, and the organic photovoltaic module was placed on the float glass.

<Example B2>

An organic photovoltaic module was produced, and the organic photovoltaic module was placed on float glass in the same manner as the manner of Example B1 except that each of the thicknesses of the first sealing layer and the second sealing layer was set at 50 µm.

<Example B3>

An organic photovoltaic module was produced, and the organic photovoltaic module was placed on float glass in the same manner as the manner of Example B1 except that each of the thicknesses of the first sealing layer and the second sealing layer was set at 60 µm.

<Example B4>

An organic photovoltaic module was produced, and the organic photovoltaic module was placed on the float glass in the same manner as the manner of Example B1 except that the thickness of the first sealing layer was set at 30 µm, and the thickness of the second sealing layer was set at 60 µm.

<Example B5>

An organic photovoltaic module was produced, and the organic photovoltaic module was placed on the float glass in the same manner as the manner of Example B1 except that the thickness of the first sealing layer was set at 60 µm, and the thickness of the second sealing layer was set at 30 µm.

<Example B6>

A thin film photovoltaic module was produced in the same manner as the manner of Example B1 except that an olefin resin having a thickness of 3 µm (Kuranbeter, M-2, manufactured by KURABO) was used as the first and second sealing layers.

<Example B7>

A thin film photovoltaic module was produced in the same manner as the manner of Example B1 except that a butyl rubber pressure sensitive adhesive having a thickness of 30 µm (manufactured by Sumitomo 3M Limited) was used as the first and second sealing layers.

<Comparative Example B1>

An organic photovoltaic module was produced, and the organic photovoltaic module was placed on the float glass in the same manner as the manner of Example B1 except that each of the thicknesses of the first sealing layer and the second sealing layer was set at 30 $\mu$m, and a temperature in pressure bonding in the vacuum laminator was set at 120°C.

<Comparative Example B2>

An organic photovoltaic module was produced, and the organic photovoltaic module was placed on the float glass in the same manner as the manner of Example B1 except that each of the thicknesses of the first sealing layer and the second sealing layer was set at 30 $\mu$m.

<Comparative Example B3>

A thin film photovoltaic module was produced in the same manner as the manner of Example B1 except that a butyl rubber pressure sensitive adhesive having a thickness of 60 $\mu$m (manufactured by Sumitomo 3M Limited) was used as the first and second sealing layers.
The evaluation results of the organic photovoltaic modules of Examples B1 to 7 and Comparative Examples B1 to 3 are listed in Table 2.

[Table 2]

Table 2

| | First Sealing Layer | | Second Sealing Layer | Laminate Temperature [°C] | X [$\mu$m] | y [$\mu$m] | x-y [$\mu$m] | Evaluation of Bubbles |
|---|---|---|---|---|---|---|---|---|
| | Material | Film Thickness [$\mu$m] | | | | | | |
| Example B1 | Epoxy-based thermal curing adhesive | 40 | The same as first sealing layer | 140 | 313 | 268 | 45 | Fair |
| Example B2 | Epoxy-based thermal curing adhesive | 50 | The same as first sealing layer | 140 | 337 | 290 | 47 | Fair |
| Example B3 | Epoxy-based thermal curing adhesive | 60 | The same as first sealing layer | 140 | 352 | 321 | 31 | Good |
| Example B4 | Epoxy-based thermal curing adhesive | 30 | Film thickness of 60 $\mu$m | 140 | 340 | 285 | 55 | Good |
| Example B5 | Epoxy-based thermal curing adhesive | 60 | Film thickness of 30 $\mu$m | 140 | 335 | 285 | 50 | Good |
| Example B6 | Olefinic thermoplastic resin | 30 | The same as first sealing layer | 140 | 332 | 256 | 76 | Good |
| Example B7 | Butyl rubber pressure sensitive adhesive | 30 | The same as first sealing layer | 140 | 363 | 303 | 60 | Good |

(continued)

| | First Sealing Layer | | Second Sealing Layer | Laminate Temperature [°C] | X [μm] | y [μm] | x-y [μm] | Evaluation of Bubbles |
|---|---|---|---|---|---|---|---|---|
| | Material | Film Thickness [μm] | | | | | | |
| Comparative Example B1 | Epoxy-based thermal curing adhesive | 30 | The same as first sealing layer | 120 | 322 | 224 | 98 | Poor |
| Comparative Example B2 | Epoxy-based thermal curing adhesive | 30 | The same as first sealing layer | 140 | 315 | 224 | 91 | Poor |
| Comparative Example B3 | Butyl rubber pressure sensitive adhesive | 60 | The same as first sealing layer | 140 | 413 | 321 | 92 | Poor |

It is clear from Table 2 that the thin film photovoltaic module of the present embodiment is a thin film photovoltaic module with favorable design quality after squeegee construction in wet pasting construction.

Reference Signs List

1 Second gas barrier layer

2 First gas barrier layer

3 Second sealing layer

4 First sealing layer

5 Device substrate

6 Lower electrode

7 Organic photoelectric conversion layer

8 Upper electrode

9 Organic photovoltaic device

10 Adhesive layer

11 Power collection line

12 Getter layer

13 Power collection line placement region

**Claims**

1. An organic photovoltaic module comprising, in turn, a first gas barrier layer, a first sealing layer, and an organic photovoltaic device,
wherein the first sealing layer has a storage modulus of $5 \times 10^6$ Pa or more and $1 \times 10^8$ Pa or less at 25°C and a frequency of 10 Hz.

2. The organic photovoltaic module according to claim 1, wherein the organic photovoltaic module is flexible.

3. The organic photovoltaic module according to claim 1 or 2, wherein the first sealing layer has a thickness of 20 $\mu$m or more and 200 $\mu$m or less.

4. The organic photovoltaic module according to any one of claims 1 to 3, wherein the organic photovoltaic module comprises, in turn, a first gas barrier layer, a first sealing layer, an organic photovoltaic device, a second sealing layer, and a second gas barrier layer.

5. The organic photovoltaic module according to claim 4, wherein a light-receiving surface is in a second sealing layer side with respect to the organic photovoltaic device.

6. The organic photovoltaic module according to any one of claims 1 to 5, wherein the organic photovoltaic module comprises, in turn, a first gas barrier layer, a first sealing layer, a thin film photovoltaic device, a second sealing layer, a second gas barrier layer, and an adhesive layer.

Sun Light

Fig.1

Sun Light

Glass

— 10
— 1
— 3

5
6
7  } 9
8

— 11
— 4
— 2

Fig.2

Sun Light

Fig.3

Sun Light

Fig.4

## INTERNATIONAL SEARCH REPORT

| International application No. |
| --- |
| PCT/JP2016/059714 |

### A. CLASSIFICATION OF SUBJECT MATTER
*H01L51/44(2006.01)i*

According to International Patent Classification (IPC) or to both national classification and IPC

### B. FIELDS SEARCHED

Minimum documentation searched (classification system followed by classification symbols)
H01L31/04-31/078, H01L51/42-51/48

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X<br>Y | WO 2013/118729 A1 (Mitsubishi Plastics, Inc.),<br>15 August 2013 (15.08.2013),<br>paragraphs [0013], [0057], [0060] to [0062],<br>[0066] to [0082]<br>& US 2014/0360573 A1<br>paragraphs [0022] to [0023], [0101], [0107] to<br>[0111], [0116] to [0138]<br>& EP 2814067 A1  & CN 104106147 A<br>& KR 10-2014-0128317 A  & TW 201336680 A | 1-5<br>6 |

| ☒ Further documents are listed in the continuation of Box C. | | ☐ See patent family annex. |
| --- | --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 02 June 2016 (02.06.16) | 21 June 2016 (21.06.16) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
| --- | --- |

Form PCT/ISA/210 (second sheet) (January 2015)

**INTERNATIONAL SEARCH REPORT**

International application No.

PCT/JP2016/059714

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y | WO 2012/029466 A1  (Mitsubishi Plastics, Inc.),<br>08 March 2012 (08.03.2012),<br>paragraphs [0016] to [0018], [0029], [0078] to<br>[0079], [0083], [0090], [0092], [0097], [0102],<br>[0116] to [0150]; claims 1 to 13; fig. 1<br>& US 2013/0206214 A1<br>paragraphs [0034] to [0036], [0049], [0110] to<br>[0111], [0117], [0132], [0136] to [0137],<br>[0145], [0151], [0180] to [0217]; claims 1 to<br>18<br>& EP 2613362 A1          & CA 2809765 A<br>& CN 103098229 A         & KR 10-2013-0100999 A<br>& TW 201221571 A         & JP 2012-54365 A<br>& JP 2012-148557 A | 1-5<br>6 |
| Y | JP 2013-48222 A  (Asahi Glass Co., Ltd.),<br>07 March 2013 (07.03.2013),<br>paragraphs [0045] to [0067]; fig. 1 to 3<br>(Family: none) | 6 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012186310 A
- WO 2011016430 A
- WO 2013180243 A
- JP 2012191194 A

**Non-patent literature cited in the description**

- Handbook of Conducting Polymers. 2007
- *Materials Science and Engineering,* 2001, vol. 32, 1-40
- *Pure Appl. Chem.,* 2002, vol. 74, 2031-3044
- Handbook of THIOPHENE-BASED MATERIALS. 2009
- **C. J. BRINKER ; G. W. SCHERER.** Sol-Gel Science. Academic Press, 1990